# EUROPEAN PATENT APPLICATION

(11) **EP 3 872 547 A1**
(43) Date of publication of application: **01.09.2021**
(21) Application number: 21157469.4
(22) Date of filing: 16.02.2021
(51) Int. Cl.: G02B 6/42, G02B 6/43, G02B 6/122, G02B 6/13

(54) **OPTICAL-ELECTRICAL SUBSTRATE PROVIDING INTERCONNECTS FOR PHOTONIC INTEGRATED CIRCUIT AND ASSOCIATED METHODS**

(30) Priority: 28.02.2020 US 202062983497 P
(71) Applicant: Corning Research & Development Corporation, Corning, New York 14831 (US)
(72) Inventor: BRUSBERG, Lars Martin Otfried, Corning, NY 14830 (US); EVANS, Alan Frank, Beaver Dams, NY 14812 (US); GRENIER, Jason Roy, Horseheads, NY 14845 (US); YEARY, Lucas Wayne, Corning, NY 14830 (US); ZAKHARIAN, Aramais Robert, Painted Post, NY 14870 (US)
(74) Representative: Sadler, Peter Frederick

(57) **Abstract**

An optical-electrical substrate for providing electrical and optical connections to a photonic integrated circuit (PIC) includes a glass body with glass optical waveguides along an upper surface, and electrically conductive vias extending through a portion of the glass body from an intermediate surface to a lower surface. The intermediate surface is arranged at an elevation positioned between the upper and lower surfaces, and may optionally support redistribution layers and an electrical integrated circuit. An optical-electrical substrate may be fabricated by defining glass optical waveguides along an upper surface of a glass body, and forming electrically conductive vias through the glass body from the intermediate surface to the lower surface. A connection method includes registering a PIC with an optical-electrical substrate as described herein; heating bonding bumps arranged between the PIC and the intermediate surface; and providing optically transmissive paths between the PIC and glass optical waveguides of the substrate.

## Description

### CROSS-REFERENCE TO RELATED APPLICATION

This application claims priority to U.S. Provisional Patent Application No. 62/983,497 filed on February 28, 2020.

### BACKGROUND

The disclosure relates generally to optical-electrical substrates and methods for interconnecting and/or co-packaging of circuits having electrical and optical functionalities, including photonic integrated circuits.

Photonic systems are based on the generation, manipulation, and/or detection of light much in the way that electronic systems are based on the generation, manipulation, and/or detection of electricity. Systems that are based on the generation, manipulation, and/or detection of both light and electricity are sometimes referred to as opto-electronic systems.

For high-speed, off-chip interconnects, co-packaging of optical transceivers with items such as electrical integrated circuits (ICs) or switching application specific integrated circuits (ASICs) has been proposed to reduce the length of electrical interconnects for high frequency (e.g., 56 Gb/s and higher) electrical signal links. This is beneficial due to the high loss and increased power consumption of electrical signals at higher frequencies.

As the demand for high-density parallel data transmission increases, a dense layout of embedded optical waveguide channels is desirable. Additionally, for certain applications it may be desirable to couple optical signals between photonic integrated circuits (PICs) and waveguides on a packaging substrate. A PIC is a device that integrates multiple (i.e., at least two) photonic functions. Functional devices that may be integrated in a PIC include low loss interconnect waveguides, power splitters, optical amplifiers, optical modulators, multiplexers/demultiplexers, filters, lasers, and detectors.

The current state of the art in connecting optical fibers to PICs involves bringing an optical fiber or an array of optical fibers (e.g., embodied in a Fiber Array Unit) in close proximity to PIC waveguides and actively aligning them to maximum power coupling. This process is time-consuming, labor-intensive, and costly, thereby presenting a major challenge for high-density integration and/or high-volume production.

Glass waveguide assemblies have been integrated into optical-electronic printed circuit boards (OE-PCBs), such as disclosed in International Patent Application Publication No. WO 2018/144199 A1 of Corning Optical Communications LLC, wherein the entire contents of the foregoing publication are hereby incorporated by reference herein. Such reference discloses that at least one glass optical waveguide may be formed from a glass substrate by selectively modifying the glass of the glass using an ion-exchange process, a laser-writing process, or a deposition and etching process.

Despite the existence of glass waveguide assemblies as part of OE-PCBs, known arrangements have limited utility due to factors such as difficulties in fabrication and system integration. Such difficulties are exacerbated when seeking to interconnect and/or co-package PICs and electrical ICs. Need therefore exists in the art for substrates and methods for interconnecting and/or co-packaging of circuits having electrical and optical functionalities that address limitations associated with conventional substrates and methods.

### SUMMARY

An optical-electrical substrate according to certain aspects is configured for providing electrical and optical connections to at least one PIC. The optical-electrical substrate includes a glass body with glass optical waveguides integrated along an upper surface, and with electrically conductive vias extending through a portion of the glass body from an intermediate surface to a lower surface. The intermediate surface is arranged at an elevation between the upper surface and the lower surface. The glass optical waveguides (which may be located along the upper surface or any other depth position) enable optical connections to be made to the at least one PIC, while the presence of electrically conductive vias along the intermediate surface allow electrical connections to be made to the at least one PIC with intervening bonding bumps. In certain implementations, the intermediate surface may further receive an electrical IC that is electrically coupled with the at least one PIC, such as through one or more redistribution layers arranged on the intermediate surface. A method for fabricating an optical-electrical substrate as described herein includes defining a plurality of glass optical waveguides in the glass body, and forming a plurality of electrically conductive vias extending through a portion of the glass body from the intermediate surface to the lower surface. A method for providing electrical and optical connections to at least one PIC includes: registering a PIC with an optical-electrical substrate as described herein; heating a plurality of bonding bumps arranged between the PIC and the intermediate surface; and providing optically transmissive paths between optical coupling areas of the PIC and glass optical waveguides of the optical-electrical substrate.

In one aspect, the disclosure relates to an optical-electrical substrate configured for providing electrical and optical connections to at least one photonic integrated circuit, wherein the optical-electrical substrate comprises: a glass body comprising an upper surface, an intermediate surface, and a lower surface; a plurality of glass optical waveguides integrated into the glass body; and a plurality of electrically conductive vias extending through a portion of the glass body from the intermediate surface to the lower surface. The intermediate surface is arranged at an elevation that is between the upper surface and the lower surface; at least a portion of the intermediate surface is laterally offset relative to the upper surface; and each of the upper surface and the intermediate surface opposes the lower surface.

In certain embodiments, the glass body comprises an upper glass body portion, a lower glass body portion, and a bonding surface between the upper glass body portion and the lower glass body portion, wherein the upper glass body portion defines the upper surface, and the lower glass body portion defines the intermediate surface and the lower surface.

In certain embodiments, the glass body comprises a unitary body structure that is devoid of different glass body portions or any bonding surface therebetween.

In certain embodiments, at least some glass optical waveguides of the plurality of glass optical waveguides may comprise ion-exchanged glass optical waveguides, laser-formed (e.g., laser-written) glass optical waveguides, or glass optical waveguides that are deposited and/or etched along the upper surface.

In certain embodiments, a plurality of electrical contact pads are arranged along the lower surface and in conductive electrical communication with the plurality of electrically conductive vias.

In certain embodiments, the glass body defines a first wall extending between the upper surface and the intermediate surface, and the first wall laterally bounds at least a portion of a cavity configured to receive an integrated circuit in electrical communication with the at least one photonic integrated circuit.

In certain embodiments, the glass body defines one or more edges or surfaces providing passive alignment features for registering the at least one photonic integrated circuit with the glass body.

In certain embodiments, the optical-electrical substrate is mounted to a secondary (e.g., organic, ceramic, organic-ceramic, glass-organic, or glass) substrate, with the plurality of electrically conductive vias of the optical-electrical substrate being in conductive electrical communication with a plurality of electrically conductive features of the secondary substrate.

In certain embodiments, at least one first redistribution layer is arranged on the intermediate surface. A plurality of first redistribution layers may be provided, with such layers comprising multiple layers of dielectric polymer having electrical transmission elements arranged therein.

In certain embodiments, at least one second redistribution layer is arranged on the bottom surface.

In another aspect of the disclosure, a method is provided for fabricating an optical-electrical substrate configured for providing electrical and optical connections to at least one photonic integrated circuit, wherein the method comprises: providing a glass body comprising an upper surface, an intermediate surface, a lower surface; defining a plurality of glass optical waveguides in the glass body; and forming a plurality of electrically conductive vias extending through a portion of the glass body from the intermediate surface to the lower surface. The intermediate surface is arranged at an elevation that is between the upper surface and the lower surface; at least a portion of the intermediate surface is laterally offset relative to the upper surface; and each of the upper surface and the intermediate surface opposes the lower surface.

In certain embodiments, the defining of a plurality of glass optical waveguides comprises laser processing portions of the glass body; ion exchange processing portions of the glass body; or at least one of etching material or depositing material along one or more surfaces of the glass body.

In certain embodiments, the glass body comprises an upper glass body portion and a lower glass body portion, the lower glass body portion defines the intermediate surface and the lower surface, and the method further comprises bonding the upper glass body portion to the lower glass body portion.

In certain embodiments, the upper glass body portion defines a first wall extending between the upper surface and the intermediate surface, and the first wall laterally bounds at least a portion of a cavity configured to receive an integrated circuit in electrical communication with the at least one photonic integrated circuit.

In certain embodiments, the method further comprises forming a plurality of first redistribution layers on the intermediate surface, wherein the plurality of first redistribution layers comprises multiple layers of dielectric polymer having electrical transmission elements arranged therein.

In certain embodiments, the method further comprises forming a plurality of second redistribution layers on the bottom surface, wherein the plurality of second redistribution layers comprises multiple layers of dielectric polymer having electrical transmission elements arranged therein.

In certain embodiments, the method further comprises mounting the glass body to a secondary substrate, and causing the plurality of electrically conductive vias of the optical-electrical substrate to be in conductive electrical communication with a plurality of electrically conductive features of the secondary substrate.

In certain embodiments, the method further comprises defining one or more edges or surfaces in the glass body configured to serve as passive alignment features for registering the at least one photonic integrated circuit with the glass body.

In another aspect, the disclosure relates to a method for providing electrical and optical connections to at least one photonic integrated circuit, wherein the method comprises: registering a photonic integrated circuit with an optical-electrical substrate, wherein the optical-electrical substrate comprises (i) a glass body comprising an upper surface, an intermediate surface, and a lower surface; (ii) a plurality of glass optical waveguides integrated into the glass body; and (iii) a plurality of electrically conductive vias extending through a portion of the glass body from the intermediate surface to the lower surface, wherein the intermediate surface is arranged at an elevation that is between the upper surface and the lower surface; at least a portion of the intermediate surface is laterally offset relative to the upper surface; and each of the upper surface and the intermediate surface opposes the lower surface; heating a plurality of bonding bumps (e.g., solder bumps, copper pillars, stud bumps, etc.) arranged between the photonic integrated circuit and the intermediate surface sufficiently to make a plurality of conductive electrical connections between electrical contacts of the photonic integrated circuit and at least some electrically conductive vias of the plurality of electrically conductive vias; and providing optically transmissive paths between optical coupling areas of the photonic integrated circuit and at least some glass optical waveguides of the plurality of glass optical waveguides.

In certain embodiments, the heating of the plurality of bonding bumps may comprise the use of a solder reflow technique, or a thermo-compression technique.

In certain embodiments, the providing of optically transmissive paths comprises promoting evanescent coupling, end coupling, or grating coupling between optical coupling areas of the photonic integrated circuit and at least some glass optical waveguides of the plurality of glass optical waveguides.

In another aspect, the disclosure relates to an optical-electrical substrate configured for providing electrical and optical connections to at least one photonic integrated circuit, the optical-electrical substrate comprising: a glass body comprising an upper surface, an intermediate surface, and a lower surface; a plurality of glass optical waveguides integrated into the glass body; and a plurality of electrically conductive traces on the intermediate surface; wherein: the intermediate surface is arranged at an elevation that is between the upper surface and the lower surface; at least a portion of the intermediate surface is laterally offset relative to the upper surface; and each of the upper surface and the intermediate surface opposes the lower surface.

In another aspect, features of any aspects or embodiments disclosed herein may be combined for additional advantage.

Additional features and advantages will be set forth in the detailed description which follows, and in part will be readily apparent to those skilled in the art from that description or recognized by practicing the embodiments as described herein, including the detailed description which follows, the claims, as well as the appended drawings.

It is to be understood that both the foregoing general description and the following detailed description are merely exemplary, and are intended to provide an overview or framework to understanding the nature and character of the claims. The accompanying drawings are included to provide a further understanding, and are incorporated in and constitute a part of this specification. The drawings illustrate one or more embodiment(s), and together with the description serve to explain principles and operation of the various embodiments.

### BRIEF DESCRIPTION OF THE DRAWINGS

**FIG. 1A** is a perspective view of a waveguide assembly formed from a glass substrate with multiple glass optical waveguides defined along an upper surface thereof.
**FIG. 1B** is a perspective view of the waveguide assembly of **FIG. 1A** following addition of a protective coating over the upper surface of the glass substrate.
**FIG. 2A** is a magnified side (x-z) cross-sectional view of a peripheral portion of a waveguide assembly showing a glass optical waveguide defined along an upper surface of a glass substrate, with the glass optical waveguide terminating prior to reaching an edge of the substrate.
**FIG. 2B** is a magnified side (y-z) cross-sectional view of the waveguide assembly of **FIG. 2A** showing glass optical waveguides defined along the upper surface of the glass substrate.
**FIG. 2C** is a perspective view of a waveguide assembly similar to the waveguide assembly shown in **FIGS. 2A-2B****,** but with glass optical waveguides extending to edges of the glass substrate.
**FIG. 3** is a schematic diagram of a laser-based optical processing system for processing a glass substrate to form glass optical waveguides proximate to or along an upper surface thereof.
**FIG. 4A** is a side cross-sectional view of an optical-electrical substrate according to one embodiment of the present disclosure, the optical-electrical substrate being fabricated of upper and lower glass body portions joined at a bonding surface, and being suitable for providing interconnects to a PIC.
**FIG. 4B** is a side cross-sectional view of an opto-electronic assembly including optical-electrical substrates according to **FIG. 4A** providing interconnects to multiple PICs and affixed along peripheral portions to a secondary substrate that supports a centrally located electronic IC.
**FIG. 5A** is a side cross-sectional view of an optical-electrical substrate according to one embodiment, the optical-electrical substrate being suitable for providing interconnects to multiple PICs and defining a recess configured to receive an electronic IC.
**FIG. 5B** is a side cross-sectional view of an opto-electronic assembly including the optical-electrical substrate of **FIG. 5A** providing interconnects to multiple PICs and supporting a centrally located electronic IC.
**FIG. 6A** is a side cross-sectional view of an optical-electrical substrate according to one embodiment, the optical-electrical substrate being suitable for providing interconnects to an opto-electronic IC having integrated optical input-output functionality.
**FIG. 6B** is a side cross-sectional view of an opto-electronic assembly including the optical-electrical substrate of **FIG. 6A** providing interconnects to an opto-electronic IC having integrated optical input-output functionality.
**FIG. 7A** is a perspective view of a portion of an optical-electrical substrate defining trenches serving as passive alignment features to facilitate alignment of an optical connector to the optical-electrical substrate.
**FIG. 7B** is a perspective view of the optical-electrical substrate portion of **FIG. 7A** following addition of guide pins to the trenches and a lid member arranged to retain the guide pins.
**FIG. 7C** is a perspective view of the optical-electrical substrate portion, guide pins, and lid member of **FIG. 7B** following the mating of a multi-fiber connector to the lid member and guide pins.
**FIG. 8** is an end cross-sectional view of a portion of a glass-based optical substrate including ion exchange waveguides arranged near an upper surface and including a laser-formed trench suitable for receiving guide pins.
**FIG. 9A** is a top plan view of a multi-fiber optical connector having protruding alignment pins and mated with a glass-based optical substrate, with the alignment pins received by peripheral slots defined in the glass-based optical substrate.
**FIG. 9B** is a side elevational view of the multi-fiber optical connector and glass-based optical substrate of **FIGS. 9A****.**
**FIG. 9C** is a perspective view of the multi-fiber optical connector and glass-based optical substrate of **FIGS. 9A** and **9B****.**
**FIG. 9D** is a top plan view of a magnified portion of the glass-based optical substrate and one alignment pin of the multi-fiber optical connector as shown in **FIGS. 9A-**9C with dimensions according to one implementation.
**FIG. 9E** is a top plan view of a magnified portion of the glass-based optical substrate and one alignment pin of the multi-fiber optical connector as shown in **FIGS. 9A-**9C with dimensions according to one implementation.
**FIG. 9F** is a perspective view of a portion of an assembly including the glass-based optical substrate and multi-fiber optical connector as shown in **FIGS. 9A-9C****,** with the addition of a cover defining a V-groove that receives an alignment pin of the multi-fiber connector.
**FIG. 10A** is an end elevational view of alignment pins of an optical connector arranged in contact with an upper surface of a glass-based optical substrate, with lower portions of the alignment pins extending into reduced width peripheral slots defined in the glass-based optical substrate.
**FIG. 10B** is a top plan view of the alignment pins and glass-based optical substrate of **FIG. 10A****.**
**FIG. 10C** is a perspective view of a ferrule portion of multi-fiber optical connector useable with the alignment pins and glass-based optical substrate of **FIGS. 10A** and **10B****.**
**FIGS. 10D** and **10E** are end elevational views of the ferrule portion of **FIG. 10C** with different numbers of optical fiber bores and different alignment hole spacing.
**FIGS. 11A-11D** illustrate steps in forming a cavity in an upper portion of a glass-based optical substrate having waveguides defined along an upper surface thereof, and mounting a PIC to the substrate within the cavity, with the cavity having large-radius transitions between an upper surface of the substrate and the cavity floor.
**FIGS. 12A-12D** illustrate steps in forming a cavity in an upper portion of a glass-based optical substrate having waveguides defined along an upper surface thereof, and mounting a PIC to the substrate within the cavity, with the cavity having increased depth regions at transitions between an upper surface of the substrate and the cavity floor.
**FIG. 13A** is a side cross-sectional view of a glass-based optical substrate including an etch-resistant mask arranged on a top surface portion thereof, following formation of a generally rectangular laser damage region in the interior of the substrate to promote preferential etching of a glass material from the substrate.
**FIG. 13B** is a side cross-sectional view of the glass-based optical substrate of **FIG. 13A** following formation of a generally rectangular cavity in an interior of the substrate following exposure of the laser damage region to an etchant.
**FIG. 14A** is a side cross-sectional view of a glass-based optical substrate including photoresist arranged on a top surface portion thereof, following formation of a generally triangular laser damage region in the interior of the substrate to promote preferential etching of a glass material from the substrate.
**FIG. 14B** is a side cross-sectional view of the glass-based optical substrate of FIG. 14A following formation of a cavity in an interior of the substrate just prior to exposure of the laser damage region to an etchant.
**FIGS. 15A-15D** illustrate steps in forming a cavity in an upper portion of a glass-based optical substrate having waveguides defined along an upper surface thereof, and mounting a PIC to the substrate within the cavity, with the cavity being wider than a window defined in an etch-resistant mask arranged along an upper surface of the substrate.
**FIG. 16** is a side cross-sectional view of an assembly including an IC with integrated optical input/output capability and an optical waveguide region along a lower surface thereof mounted in a cavity of an optical-electrical substrate according to one embodiment, with the optical waveguide region of the IC being substantially coplanar with glass optical waveguides arranged along an upper surface of the substrate.
**FIG. 17** is a schematic top plan view of an optical-electrical substrate supporting a centrally located electronic IC and four peripherally located groups of optical transceiver elements (e.g., PICs), showing a potential layout for glass optical waveguides between one group of transceiver elements and the IC.
**FIG. 18** is a side cross-sectional view of an opto-electronic assembly including an optical-electrical substrate according to one embodiment, with conductive vias arranged to conduct power and ground signals vertically through the optical-electrical substrate, and with electrical transmission elements of a first redistribution layer arranged to conduct signals laterally between multiple PICs and an electronic IC.
**FIG. 19A** is a side cross-sectional view of an opto-electronic assembly including an optical-electrical substrate according to one embodiment, with conductive vias arranged to conduct power and ground signals vertically through the optical-electrical substrate, and with fan-out electrical contacts arranged between the substrate and an electronic IC.
**FIG. 19B** is a top plan view of a fan-out power contact of the opto-electronic assembly of **FIG. 19A****.**
**FIG. 19C** is a top plan view of a fan-out ground contact of the opto-electronic assembly of **FIG. 19A****.**
**FIG. 20** is top plan view of one arrangement of electrical contacts of a redistribution layer useable with an optical-electrical substrate as disclosed herein, including an outer row of signal contacts and an inner row of ground contacts.
**FIG. 21** is a side cross-sectional view of a portion of an opto-electronic assembly including an optical-electrical substrate receiving an optical connector and a PIC having an integrated electronic IC.
**FIG. 22** is a side cross-sectional view of a portion of an opto-electronic assembly including an optical-electrical substrate receiving an optical connector and a PIC serving as an interposer with through-silicon vias, and including an electronic IC mounted to a top surface of the PIC.
**FIG. 23** is a side cross-sectional view of a portion of an opto-electronic assembly including an optical-electrical substrate receiving an optical connector as well as a PIC and an electronic IC that is laterally adjacent to the PIC.
**FIG. 24** is a side cross-sectional view of a portion of an opto-electronic assembly including an optical-electrical substrate receiving an optical connector as well as a PIC, with an electronic IC having through-silicon vias serving as an interposer and arranged between the PIC and the optical-electrical substrate.
**FIG. 25** is a partially exploded, side cross-sectional view of a portion of an opto-electronic assembly including an optical-electrical substrate receiving an optical connector and configured to receive a PIC having a passive alignment feature to promote edge coupling between the PIC and glass optical waveguides of the optical-electrical substrate.
**FIG. 26** is a side cross-sectional view of the opto-electronic assembly portion of **FIG. 25** following mounting of the PIC to the substrate.
**FIG. 27** is a side cross-sectional view of a portion of an opto-electronic assembly including an optical-electrical substrate receiving an optical connector and a PIC having an integrated electronic IC, with at least one grating coupling element arranged between the PIC and glass optical waveguides of the optical-electrical substrate.
**FIG. 28** is a side cross-sectional view of a portion of an opto-electronic assembly including a composite optical-electrical substrate with a glass portion defining glass optical waveguides laminated over a non-glass substrate portion defining conductive vias, and with the composite optical-electrical substrate receiving an optical connector and a PIC having an integrated electronic IC.
**FIG. 29** is a side cross-sectional view of a portion of an opto-electronic assembly including a composite optical-electrical substrate with a glass portion defining glass optical waveguides and conductive vias being partially embedded in a non-glass substrate portion defining conductive vias, with the composite optical-electrical substrate receiving an optical connector and a PIC having an integrated electronic IC.
**FIG. 30** is a schematic top plan view of a rectangular optical-electrical substrate supporting a centrally located electronic IC (e.g., an ASIC) and four peripherally located groups of PICs, with straight waveguide groups extending from edges of the optical-electrical substrate to the PICs.
**FIG. 31** is a schematic top plan view of a rectangular optical-electrical substrate supporting a centrally located electronic IC (e.g., an ASIC) and four peripherally located groups of PICs, with fan-out waveguide groups extending from PICs to the edges of the optical-electrical substrate.
**FIG. 32** is a schematic top plan view of a rectangular optical-electrical substrate supporting a centrally located electronic IC (e.g., an ASIC) and four peripherally located groups of PICs, with a combination of fan-out, branch, and ninety degree arc waveguide groups extending from PICs to the edges of the optical-electrical substrate.
**FIG. 33** is a schematic top plan view of a rectangular optical-electrical substrate supporting a centrally located electronic IC (e.g., an ASIC) and four peripherally located groups of PICs, with a combination of fan-out, branch, and straight waveguide groups extending from PICs to edges of the optical-electrical substrate.
**FIG. 34** is a schematic top plan view of an octagonal optical-electrical substrate supporting a centrally located electronic IC (e.g., an ASIC) and four peripherally located groups of PICs, with straight waveguide groups extending from edges of the optical-electrical substrate to the PICs.
**FIG. 35** is a schematic top plan view of a rectangular optical-electrical substrate supporting four peripherally located groups of PICs, with multiple waveguide groups serving as part of an optical circuit to interconnect the PICs.
**FIG. 36** is a schematic top plan view of a rectangular optical-electrical substrate supporting a high port count PIC, with multiple waveguide groups connecting the PIC along four sides thereof.
**FIG.** 37 is a schematic top plan view of an optical-electrical substrate serving as a motherboard for connecting to one or more fiber interfaces at a front panel (or backplane) with PICs located mid-board, and including mid-board lasers.
**FIG. 38** provides a schematic representation of refractive index profile for an ion exchange glass waveguide.
**FIG. 39** a side cross-sectional view of a portion of an opto-electronic assembly including an optical-electrical substrate having glass optical waveguides defined along first and second opposing surfaces thereof and having PICs mounted along the first and second opposing surfaces, and receiving optical connectors proximate to the first and second surfaces thereof as well as an electronic IC along the first surface, with the optical-electrical substrate being mounted over a printed circuit board.

### DETAILED DESCRIPTION

The embodiments set forth below represent the necessary information to enable those skilled in the art to practice the embodiments and illustrate the best mode of practicing the embodiments. Upon reading the following description in light of the accompanying drawing figures, those skilled in the art will understand the concepts of the disclosure and will recognize applications of these concepts not particularly addressed herein. It should be understood that these concepts and applications fall within the scope of the disclosure and the accompanying claims.

It will be understood that, although the terms first, second, etc. may be used herein to describe various elements, these elements should not be limited by these terms. These terms are only used to distinguish one element from another. For example, a first element could be termed a second element, and, similarly, a second element could be termed a first element, without departing from the scope of the present disclosure. As used herein, the term "and/or" includes any and all combinations of one or more of the associated listed items.

Relative terms such as "below" or "above" or "upper" or "lower" or "horizontal" or "vertical" may be used herein to describe a relationship of one element, layer, or region to another element, layer, or region as illustrated in the drawing figures. It will be understood that these terms and those discussed above are intended to encompass different orientations of the device in addition to the orientation depicted in the drawing figures.

The terminology used herein is for the purpose of describing particular embodiments only and is not intended to be limiting of the disclosure. As used herein, the singular forms "a," "an," and "the" are intended to include the plural forms as well, unless the context clearly indicates otherwise. It will be further understood that the terms "comprises," "comprising," "includes," and/or "including" when used herein specify the presence of stated features, integers, steps, operations, elements, and/or components, but do not preclude the presence or addition of one or more other features, integers, steps, operations, elements, components, and/or groups thereof.

Unless otherwise defined, all terms (including technical and scientific terms) used herein have the same meaning as commonly understood by one of ordinary skill in the art to which this disclosure belongs. It will be further understood that terms used herein should be interpreted as having a meaning that is consistent with their meaning in the context of this specification and the relevant art and will not be interpreted in an idealized or overly formal sense unless expressly so defined herein.

As introduced previously, an optical-electrical substrate according to certain aspects includes a glass body with glass optical waveguides integrated along an upper surface, and with electrically conductive vias extending through a portion of the glass body from an intermediate surface to a lower surface, wherein the intermediate surface is arranged at an elevation between that of the upper and lower surfaces. By elevating glass optical waveguides relative to the electrically conductive vias, optical connections may be made to at least one PIC while accommodating the thickness of solder regions that make electrical connections between the at least one PIC and the electrically conductive vias.

Before describing optical-electrical substrates and their fabrication, the formation of glass optical wavelengths in a glass substrate will be introduced.

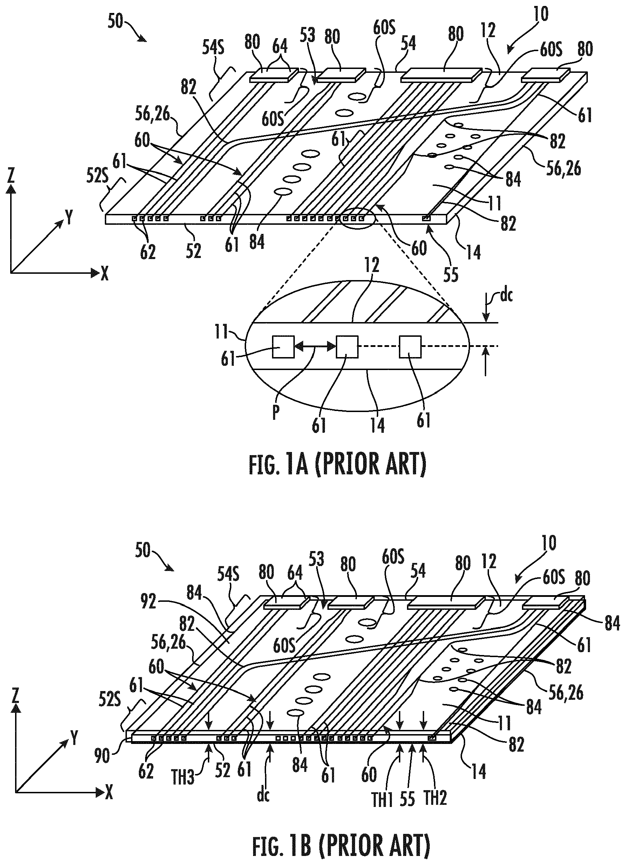

**FIG. 1A** is a perspective view of a glass waveguide assembly 50 formed from a glass substrate 10 with multiple glass optical waveguides ("waveguides") 61 defined with the glass substrate 10 (e.g., proximate to a top surface 12 thereof). **FIG. 1B** is a perspective view of the waveguide assembly 50 of **FIG. 1A** following addition of a protective coating 90 over the top surface 12 of the glass substrate 10. The glass waveguide assembly 50 has a front end 52, a back end 54, and sides 56 that respectively correspond to boundaries of the glass substrate 10. The glass waveguide assembly 50 also includes a top side 53 and a bottom side 55. The glass waveguide assembly 50 also includes a front-end assembly section 52S having the front end 52, and a back-end assembly section 54S having the back end 54.

With reference to **FIGS. 1A** and **1B****,** the glass waveguide assembly 50 includes waveguides 61, which can define a waveguide array 60. Reference may be made herein to multiple waveguides 61 as well as to one or more waveguide arrays 60 by way of illustration.

The waveguides 61 are formed within a body 11 of the glass substrate 10 and run generally in the y-direction from (at or near) the front end 52 to (at or near) the back end 54 of the glass substrate 10. Each waveguide 61 includes a front waveguide end 62 at or adjacent to the front end 52 of glass substrate 10 and a back end 64 at or near the back end 54 of the glass substrate 10. The waveguide array 60 includes a back-end section 60S that includes waveguide back ends 64. The waveguides 61 can also run from the front end 52 of the glass substrate 10 or from the back end 54 of the glass substrate 10 to one of sides 56 of the glass substrate 10, e.g., by a combination of straight and/or curved waveguide sections 82.

The waveguides 61 are formed from glass, and in certain examples may be formed within a glass material of the body 11 by modifying the glass composition. In certain examples, this compositional modification may be accomplished by ion diffusion, by laser writing, or by a combination thereof. Thus, in certain examples, waveguides 61 may be formed within the body 11 of the glass substrate 10 without removing any glass from the body 11 or adding any glass to the body 11. In this context, it is noted that ion-diffusion does not result in the removal of glass or the addition of glass, but instead alters the composition of the glass by replacing existing mobile alkali ions in the glass with other alkali ions (e.g., replacing Na+ with K+) from an outside source, such as a molten bath. Likewise, laser writing does not remove any glass from the body 11 or add glass thereto, but instead locally alters the structure of the glass by locally compacting it, which in turn locally increases the refractive index.

In an example, the glass substrate 10 is made of ion-exchangeable glass, i.e., one that contains alkali ions such as Na⁺. An example material for glass substrate 10 is a chemically strengthened glass or a glass suitable for chemical strengthening. An example of such a glass is Gorilla® glass, available from Corning, Inc., Corning, New York. In an example, glass substrate 10 is made of a Ag⁺ ion-exchanged glass, e.g., where Ag⁺ has been exchanged for Na⁺ in the glass substrate. An ion exchange process for defining waveguides may include a single- or multi-step thermal or field-assisted ion-exchange with or without use of a mask layer for defining the waveguide layout. If desired, a waveguide layout may be defined by a mask layer formed on the top surface 12 of the glass substrate 10 prior to the ion-exchange. Waveguide layouts can be defined through the position of a focused laser by sequential laser writing. The resulting waveguides can be straight waveguides, curved waveguides, etc., and can include optical features or components such as tapers, crossings, splitters, combiners, and arcs, which may be combinable in fan-out or fan-in arrays in certain embodiments.

The depth dC to which waveguides 61 reside relative to the top surface 12 (or to a bottom surface 14) of the glass substrate 10 can vary, with reference to the magnified inset portion of **FIG. 1A****).** Likewise, the pitch p of a waveguide array 60 can vary with position, and in particular can vary in the y-direction as well as in the z-direction (e.g., in instances case where the body 11 supports different rows of waveguides 61 at different depths within body 11). Each waveguide 61 can include a tapered section and can also vary in size along its length. The path of each waveguide 61 can also vary, i.e., it need not run in a straight line, and as noted above need not run in a given x-y plane. The waveguides 61 can be single mode or multimode. In certain examples, the back waveguide ends 64 may define respective optical quality end faces, which in an example can be formed by polishing (e.g., laser polishing or mechanical polishing) or score and break (e.g. diamond wheel scoring or laser scoring and separation).

The glass waveguide assembly 50 also includes at least one waveguide termination member ("connector") 80 that terminates at least one waveguide 61 (e.g., at or adjacent to the back waveguide end 64) at connector region(s) 15. In an example, a single connector 80 may embody a multi-waveguide connector (e.g., a MT type or MPO type connector) that terminates multiple waveguides 61. In an example, each connector 80 may terminate a corresponding array 60 of one or more waveguides 61. In another example, at least one connector 80 may include waveguides 61 from different waveguide arrays 60. In an example, connector 80 encloses the back-end array section 60S of waveguide array 60 at a connector region 15.

The glass waveguide assembly 50 can also include one or more OE-PCB features or components 84 to facilitate the use of the glass waveguide assembly 50 in forming an OE-PCB, as described below. Exemplary OE-PCB features or components 84 include conducting (e.g., metal-filled) vias, insulating (e.g., polymer-filled) vias, electrical (conducting) contacts, electrical (conducting) wiring, optical vias, slots, cut-outs, polymer-filled cut-outs, open holes, perforations, fiducials, alignment features, etc. In an example, OE-PCB features or components 84 may be formed by drilling, etching, milling, depositing, laser ablation, etc. In particular, cut-outs are relatively large sections removed from glass substrate 10 and that can be used for mounting glass waveguide assembly 50 to a PCB or OE-PCB. If desired, cut-outs can be filled with a non-glass material (e.g., a polymer), some or all of which can be removed later on in the OE-PCB fabrication process. The OE-PCB features or components 84 for alignment are formed where needed to allow for a simple passive alignment process for connectors 80 and for other photonic devices of an OE-PCB.

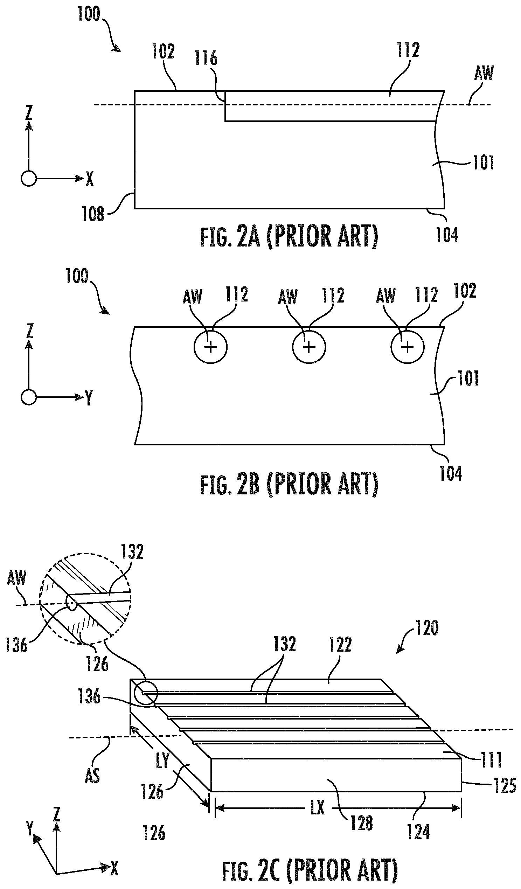

With reference to **FIG. 2B****,** the glass waveguide assembly 50 includes a protective coating 90 that has an outer surface 92. The protective coating 90 covers at least a substantial portion of top surface 12 of the glass substrate 10. In an example, protective coating 90 covers substantially the entire top surface 12. Also in an example, protective coating 90 covers at least a portion of bottom surface 14. Further in the example, protective coating 90 also covers at least a portion of sides 56. In an example, protective coating 90 is applied to the entire glass substrate 10 except optionally for select regions (e.g., one or more connector regions 15) so that the glass substrate is substantially encapsulated. Thus, the protective coating 90 may or may not include the one or more connector regions 15. In another example, protective coating 90 runs the length in the y-direction of top surface 12 except for the one or more connector regions 15 and further in the example does not extend to sides 56. In an example, protective coating 90 is selectively applied to some or all of the OE-PCB features or components 84 of glass waveguide assembly 50. In an example, the protective coating 90 is applied to the same portion of top surface 12 of glass substrate 10 below which, or at which, the waveguide array 60 is supported. In an example, the protective coating 90 may include a mechanically and thermally reliable material such as resin, polymer, acrylate, silicone, benzocyclobutene, Ormocer or Siloxane that can withstand thermal processes such as PCB lamination.

In an example, the protective coating 90 is a dielectric material compatible with conventional PCB processing, such as a polymer or a resin. If connectors 80 are formed prior to applying protective coating 90, the connector regions 15 can be left uncoated, e.g., by using a masking process or a selective deposition or coating process or lift-off process. In other examples, connectors 80 include a portion of protective coating 90 as formed on connector regions 15.

The protective coating 90 may function to protect the glass substrate 10 and any other OE-PCB features or components 84 of the glass waveguide assembly 50 during subsequent PCB processing, which can involve relatively high temperatures. A related function of the protective coating 90 is to facilitate the use of PCB processing techniques forming the glass waveguide assembly 50 as well as for forming an OE-PCB as described below. Thus, in an example, the protective coating 90 may be made of a thermally stable material, including such materials that are optically transparent. In an example, the protective coating 90 has a thickness TH2 in the range from 1 µιη to 200 µιη. Thus, in an example, glass waveguide assembly 50 has a thickness TH3 = TH1 + 2(TH2) when top and bottom surfaces 12 and 14 of glass substrate 10 are coated, or has a thickness TH3 = TH1 + TH2 when only the top surface of the glass substrate is coated. In certain instances, less than all OE-PCB features or components 84 of the glass waveguide assembly 50 are encapsulated within the protective coating 90. For example, some of the OE-PCB features or components 84 (e.g., conductive vias 110) can extend through protective coating 90. Likewise, connectors 80 as well as some of the optical features or components 82 and the OE-PCB features or components 84 can also extend from or otherwise not be coated with protective coating 90. In an example, OE-PCB features or components 84 in the form of electrical wiring can be formed on an outer surface 92 of the protective coating 90.

**FIG.** 2A is a magnified side (x-z) cross-sectional view of a peripheral portion of a waveguide assembly 100 showing a waveguide 112 defined along an upper surface 102 of a glass substrate 101, with the waveguide 112 terminating prior to reaching an edge 108 of the glass substrate 101. In an example, the substrate 101 may comprises a glass-based material, such as a glass, a glass-ceramic or a crystal. Example glasses can include soda-lime, borosilicate, germanosilicate, aluminosilicate ion-exchanged glasses, non-ion-exchanged glasses, chalcogenide glasses, or fused silica. Example crystals can include sapphire, diamond, lithium niobate, lithium tantalite, lithium triborate, barium borate, silicon, InP, and GaAs. In certain examples, the substrate 101 can be chemically strengthened, wherein the chemical strengthening can be localized or can extend over the entire volume of the substrate 101. As shown, the waveguide 112 has a waveguide axis AW and an end surface (facet) 116. The example waveguide 112 has an end surface 116 that resides with the glass substrate 101.

**FIG. 2B** is a magnified side (y-z) cross-sectional view of the waveguide assembly 100 of **FIG. 2A** showing three waveguides 112 defined along the upper surface 102 of the glass substrate. In an example, the waveguides 112 can be formed by an ion-exchange process. In another example, the waveguides 112 can be formed using a laser-writing process. In other examples, the waveguides 112 can be formed using an ion-beam milling process, a photolithography process, an electron-beam lithography process, a thin-film deposition process, a lamination process, etching, deposition, and any other waveguide-forming process known in the art.

Generally, the waveguides 112 define localized regions of increased refractive index relative to remainder of the glass substrate 101. Two example techniques for forming the waveguides 112 include ion exchange and laser writing. For waveguides 112 formed within the glass substrate 101, the surrounding portion of the glass substrate 101 and the region immediately adjacent to the upper surface 102 (when the waveguide is at or near the upper surface) define a cladding for the waveguide 112. For ease of illustration and discussion, waveguides 112 considered herein are shown as formed within the substrate 101 and having a definite boundary with the substrate 101.

**FIG. 2C** is a perspective view of a waveguide assembly 120 similar to the waveguide assembly 100 shown in **FIGS. 2A-2B****,** but with glass optical waveguides ("waveguides") 132 extending to front and rear faces 125, 126 of a glass substrate 121. The glass substrate 121 further includes an upper surface 122, a lower surface 124, and side edges 128. The glass substrate 121 has central substrate axis AS that runs through a center of the glass substrate 121 in the x-direction, as well as a length LX in the x-direction and a length LY in the y-direction. As illustrated, the waveguides 132 run in the x-direction and comprise sections of the glass substrate 121 that have been processed to change one or more optical properties thereof. As shown, each waveguide 132 includes an end surface 136 (facet) that resides at the front face 126 of the glass substrate 121, and may include another end surface (not shown) residing at the rear face 125.

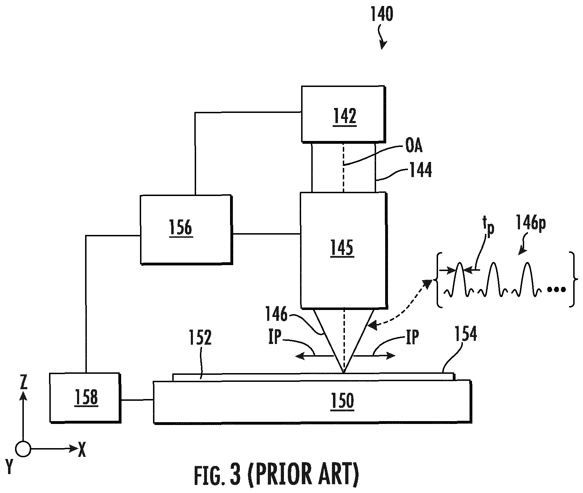

**FIG.** 3 is a schematic diagram of a laser-based optical processing system ("system") 140 for processing a glass substrate 152 to form waveguides along an upper surface thereof. The system 140 includes a laser source 142 that emits a laser beam 144 along an optical axis OA. In an example, the laser source 142 is configured to produce pulses 146p having pulses of suitably short duration (e.g., pulses of less than 10 picoseconds). The system 140 also includes a focusing lens 145 arranged to receive the laser beam 144, and a movable support stage 150 that supports the glass substrate 152. The movable support stage 150 is operably connected to a stage controller 158 that controls movement of the support stage 150. The focused laser beam 146 moves relative to the glass substrate 152 over an irradiation path IP and is impinged on the upper surface 154 of the glass substrate 152. The system 140 also includes a main controller 156 connected to the laser source 142, the focusing lens 145, and the stage controller 158 to control operation of the system 140 to define waveguides in the glass substrate 152 (e.g., proximate to the upper surface 154).

Having described methods and apparatuses for forming waveguides in glass substrates, optical-electrical substrates according to various embodiments, and assemblies incorporating the same, will be introduced. Various embodiments provide an optical-electrical substrate that includes a glass body with glass optical waveguides integrated along an upper surface, and with electrically conductive vias extending through a portion of the glass body from an intermediate surface to a lower surface, wherein the intermediate surface is arranged at an elevation intermediately positioned between the upper surface and the lower surface. In certain embodiments, a difference in elevation between the intermediate surface and the upper surface may be provided by bonding an upper glass body portion to a lower glass body portion, wherein a boundary between the upper and lower glass body portions coincides with the intermediate surface. In certain embodiments, the body comprises a unitary body structure that is devoid of different glass body portions or any bonding surface therebetween, wherein features of different elevations may be fabricated by any suitable techniques. In certain embodiments, multiple intermediate surfaces may be provided. In certain embodiments, glass substrates may include glass optical waveguides along multiple (e.g., upper and lower) surfaces thereof, and may be arranged to receive at least one PIC along the upper surface plus at least one PIC along the lower surface.

In certain embodiments, glass substrates that incorporate glass optical waveguides may include one or more cavities, edges, surfaces, precision slots, and/or other alignment features suitable for receiving electronic ICs. Glass optical waveguides can provide an optical connectivity solution based on the same substrate used for embedding ICs, such as to provide electrical and optical connection (e.g., fan-out) functionality. This may eliminate the need for separate fiber array units attached to a transceiver (e.g., PIC) before or after assembly.

Optical waveguides near the surface of the glass that connect to PIC waveguides (Figure D4), can be realized in the glass using laser waveguide writing process, or by ion exchange (IOX) process. In certain embodiments, waveguides can have a smaller pitch on the PIC side (e.g., 10 um to 125um) and a larger pitch (e.g. 250µm on a fan-out side) for fiber connectivity at an edge of a glass interposer or substrate.

Glass optical waveguides may be formed on an optical-electrical substrate by any suitable process disclosed herein, such by a laser waveguide writing process, by an ion exchange process, or another process. Thereafter, one or more electrical redistribution layers may be patterned on one or more surfaces of the substrate, including formation of electrical transmission elements and application of dielectric material. When a PIC (or other Si chip) is assembled, the height of bonding bumps (e.g., solder bumps) may be adjusted to the height of cavity over which, or into which, at least a portion will be mounted. Such height is selected to cause the optical interface of the PIC to be in contact with the upper surface of the substrate on or adjacent to glass optical waveguides thereof. The benefit of this approach is that the optical alignment is achieved during the chip assembly process (e.g., solder reflow mounting or thermo-compression bonding of a PIC or other Si-chip to an optical-electrical substrate). In certain embodiments, light is coupled from an inverted taper of the PIC (or other Si-chip) to the glass optical waveguides of the substrate by an evanescent field. Alternatively, end coupling or grating coupling may be used.

Various methods may be used to effectuate electrical coupling of a PIC or other Si-chip to an optical electrical substrate while simultaneously providing an optical interface of the PIC or other Si-chip in contact with the upper surface of the optical electrical substrate at a position on or adjacent to glass optical waveguides thereof. In certain embodiments, a solder reflow technique may be used. For a Sn-Pb eutectic solder assembly, a solder element may be preheated to a temperature in a range of 100°C to 150°C for a period of 60-120 seconds, followed by maintenance of a temperature in a range of 183°C to 225°C (or 183°C to 225°C) for a period of 60-150 seconds, followed by cooling. For a Pb-free eutectic solder assembly, a solder element may be preheated to a temperature in a range of 150°C to 200°C for a period of 60-180 seconds, followed by maintenance of a temperature in a range of 217°C to 245°C (or 217°C to 260°C) for a period of 60-150 seconds. In certain embodiments, a thermo-compression bonding technique may be used, involving application of a combination of force and temperature (e.g., at a temperature of about 300°C) with preheat of the substrate and component (PIC, ASIC) and a bonding time of a few seconds up to tens of seconds. The temperature may be adjusted to a higher or lower value depending on the amount of compressive force applied during heating. In certain embodiments, the photonic integrated circuit and the optical-electrical substrate may be preheated before bonding bumps are heated sufficiently to permit bonding to occur.

Various optical-electrical substrates and assemblies utilizing same according to various embodiments will now be described.

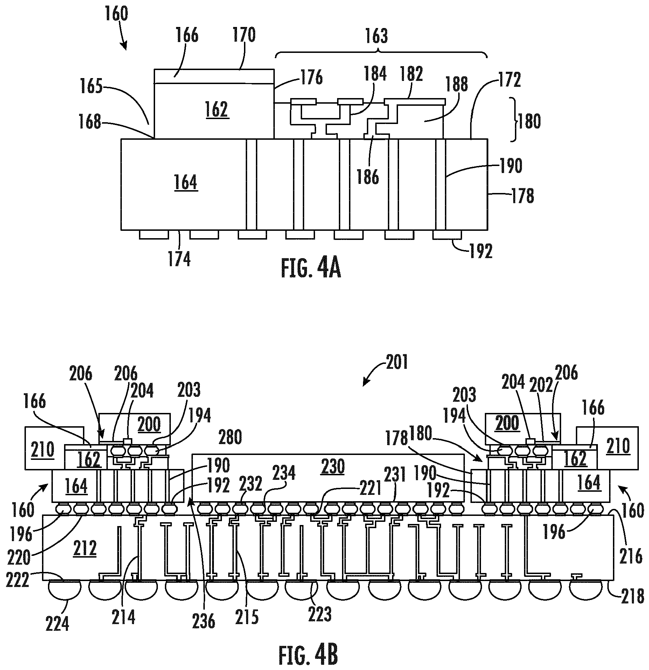

**FIG. 4A** is a side cross-sectional view of an optical-electrical substrate 160 according to one embodiment of the present disclosure, the optical-electrical substrate 160 being fabricated of an upper glass body portion 162 and a lower glass body portion 164 that are joined at a bonding surface 168. Bonding between the upper and lower glass body portions 162, 164 may be accomplished by any suitable technique, such as anodic bonding, adhesive bonding, or the like. The upper glass body portion 162 defines an upper surface 170, the lower glass body portion 164 defines a lower surface 174, and an intermediate surface 172 is provided at an elevation between the upper and lower surfaces 170, 174 that coincides with the bonding surface 168. The upper glass body portion 162 is smaller in width than the lower glass body portion 164, such that a portion 163 of the intermediate surface 172 is laterally offset relative to the upper surface 170. A peripheral recess 165 is provided to one side of the upper glass body portion 162, such as may be useful for receiving a portion of an optical connector (not shown). Another side of the upper glass body portion 162 includes a first wall (or edge) 176 extending between the upper surface 170 and the intermediate surface 172. The lower glass body portion 164 further includes a second wall (or edge) 178 extending between the intermediate surface 172 and the lower surface 174. One or more (typically multiple) glass optical waveguides ("waveguides") 166 are defined in the upper glass body portion 162 proximate to the upper surface 170. The lower glass body portion 164 defines multiple electrically conductive vias 190 extending from the intermediate surface 172 and the lower surface 174, with at least some of the electrically conductive vias 190 being in electrical communication with lower contact pads 192 arranged along the lower surface 174. At least one redistribution layer 180 is supported by the intermediate surface 172, and includes electrical transmission elements 184 arranged within dielectric material 188 (e.g., dielectric polymer, including low-dielectric polymer materials such as benzocyclobutene (BCB) or Ajinomoto buildup film (ABF)), with the electrical transmission elements 184 providing conductive paths between (i) the electrically conductive vias 190 defined in the lower glass body portion 164, and (ii) upper contact pads 182 arranged along an upper surface of the at least one redistribution layer 180. The at least one redistribution layer 180, which may comprise multiple layers of conductive and dielectric material(s), may serve to adjust a pitch between the electrically conductive vias 190 and the upper contact pads 182. As shown, a total height of the at least one redistribution layer 180 is less than a height of the upper glass body portion 162.

**FIG. 4B** is a side cross-sectional view of an opto-electronic assembly 201 including optical-electrical substrates 160 according to **FIG. 4A** that, in combination with a secondary (e.g., organic, ceramic, organic-ceramic, glass-organic, or glass) substrate 212, are arranged to receive optical connectors 210 and provide interconnects between multiple PICs 200 and an electronic IC 230. Each optical-electrical substrate 160 receives an optical connector 210 to promote optical coupling between the waveguides 166 and optical fibers (not shown) of the optical connector 210. Each optical-electrical substrate 160 provides optical and electrical connections to a different PIC 200. For each optical-electrical substrate 160, waveguide overlap regions 206 promote optical coupling between glass optical waveguides 166 and waveguide regions 202 of a PIC 200, with each waveguide region 202 being coupled with an optical transducer 204. Electrically conductive vias 190 of each optical-electrical substrate 160 are electrically coupled to a PIC 200 by the at least one redistribution layer 180 and bonding bumps 194 coupled with electrical contact pads 203 of the PIC 200. Presence of the glass optical waveguides 166 of each optical-electrical substrate 160 at a position that is elevated relative to the at least one redistribution layer 180 provides vertical space for bonding bumps 194 to be arranged between the optical-electrical substrate 160 and the corresponding PIC 200. Each optical-electrical substrate 160 further includes lower contact pads 192 that are coupled with upper peripheral contact pads 220 of the secondary substrate 212 via bonding bumps 196. The upper peripheral contact pads 220 are coupled with peripheral conductive vias 214 of the secondary substrate 212 that in combination with peripheral vias 214 conduct electrical (e.g., data) signals to lower peripheral contact pads 222. A narrow gap 236 is provided between each PIC 200 and the IC 230. Electrical traces (connections) along the upper surface 216 may communicate electrical signals between the PICs 200 and the IC 230. A bottom surface 231 of the IC 230 includes contact pads 232 that are coupled via bonding bumps 234 to upper central contact pads 221 of the secondary organic substrate 212. Central conductive vias 215 of the secondary substrate 212 convey power and ground signals to lower central contact pads 223. Bonding bumps 224 coupled to the lower peripheral contact pads 222 and the lower central contact pads 221 (both arranged along a lower surface 218 of the secondary substrate 212) may be used to join the opto-electronic assembly 201 to an electronic device (not shown). As can be appreciated, the contact pads 220, 221, 222, 223, electrical traces/connections on the upper surface 216, and conductive vias 214, 215 are examples of electrically conductive features on the secondary substrate 212.

Although **FIG. 4B** shows two optical-electrical substrates 160 that appear to be disconnected from one another, any suitable number of optical-electrical substrates 160 may be provided (e.g., around a perimeter of one or more ICs). In certain embodiments, the features of two or more optical-electrical substrates 160 may be integrated into a single optical-electrical substrate, which may define a window-like (e.g., central) aperture for receiving at least one IC (e.g., IC 230). Additionally, a PIC 164 according to FIG. 4B (and according to various other embodiments shown herein) that is coupleable with an optical-electrical substrate 160 may have an edge width in a range of about 3 mm to 20 mm.

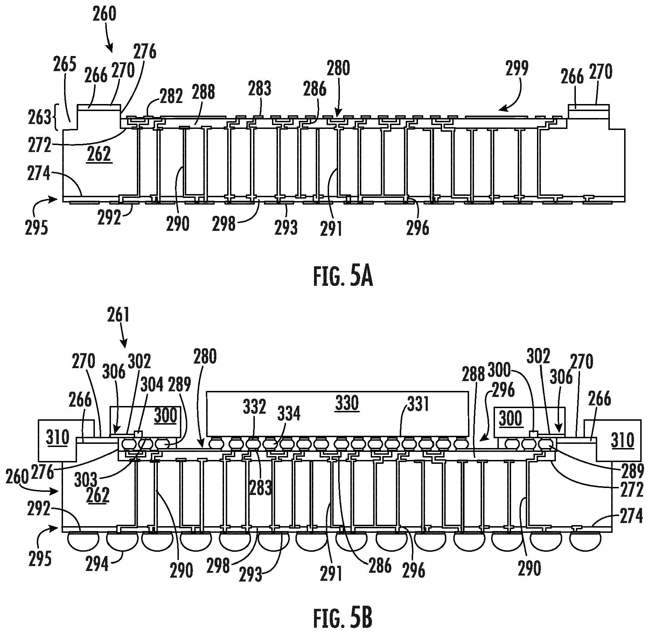

**FIG. 5A** is a side cross-sectional view of an optical-electrical substrate 260 according to one embodiment, with the optical-electrical substrate 260 including a glass body 262 having elevated portions 263 that each define an upper surface 270 and include one more glass optical waveguides ("waveguides") 266 proximate to the upper surface 270. In certain embodiments, the glass body 262 may have a length in a range of from 50 mm to about 120 mm. The optical-electrical substrate 260 further includes a lower surface 274 as well as an intermediate surface 272 that is provided at an elevation between the upper and lower surfaces 270, 274. The elevated portions 263 are narrower in width than the remainder of the optical-electrical substrate 260, with a laterally offset portion of the intermediate surface 272 defining a cavity 299 that is suitable for receiving at least a portion of an IC (not shown). Additionally, peripheral recesses 265 positioned outset relative to the elevated portions 263 are suitable for receiving portions of optical connectors (not shown). Each elevated portion 263 includes a wall (or edge) 276 that extends between the upper surface 270 and the intermediate surface 272, and that laterally bounds a portion of the cavity 299. Within the cavity 299, at least one first redistribution layer 280 is supported by the intermediate surface 272, and includes electrical transmission elements 286 arranged within dielectric material (e.g., dielectric polymer) 288, as well as upper contact pads 283. The lower surface 274 also supports at least one second redistribution layer 295, which includes electrical transmission elements 296 arranged within dielectric material 298, with lower peripheral contact pads 292 and lower central contact pads 293 further being arranged in contact with the at least one second redistribution layer 295. The optical-electrical substrate 260 also defines peripheral conductive vias 290 and central conductive vias 291 that extend from the intermediate surface 272 to the lower surface 274. In use, the peripheral conductive vias 290 may be used to carry data signals (e.g., to or from PICs), while the central conductive vias 291 may be used to carry power and ground signals (e.g., to at least one IC).

**FIG. 5B** is a side cross-sectional view of an opto-electronic assembly 261 including the optical-electrical substrate 260 of **FIG. 5A** arranged to receive optical connectors 310 and to provide interconnects between multiple PICs 300 and an IC 330. Each elevated portion 263 (labeled in **FIG. 5A**) receives an optical connector 310 to promote optical coupling between the waveguides 266 and optical fibers (not shown) of the optical connector 310. Additionally, each elevated portion 263 is arranged to contact a different PIC 300 to promote optical coupling between the waveguides 266 and waveguide regions 302 of an associated PIC 300, with each waveguide region 302 being coupled with an optical transducer 304 of the PIC 300. For each PIC 300, waveguide regions 302 overlap waveguides 266 of the optical-electrical substrate 260 at waveguide overlap regions 306 that promote optical coupling between the waveguide regions 302 and the waveguides 266. Bonding bumps 289 are provided between electrical contact pads 303 of each PIC 300 and the at least one first redistribution layer 280. Presence of the waveguides 266 of the optical-electrical substrate 260 at a position that is elevated relative to the at least one first redistribution layer 280 provides vertical space for bonding bumps 289 to be arranged between the optical-electrical substrate 260 and the PICs 300. Electrical transmission elements 286 and/or surface traces of the at least one first redistribution layer 280 may be used to convey electrical signals between the PICs 300 and the IC 330. Additionally, bonding bumps 334 are provided between the IC 330 and the at least one first redistribution layer 280, to provide electrical connections between electrical contact pads 332 along a bottom surface 331 of the IC 330 and electrical contact pads 283 along the at least one first redistribution layer 280. The peripheral conductive vias 290 and the central conductive vias 291 within the optical-electrical substrate 260 are provided to convey data signals and power/ground signals, respectively, between the PICs 300 and the IC 330 to the at least one second redistribution layer 295. Bonding bumps 294 coupled to the lower peripheral contact pads 292 and the lower central contact pads 293 may be used to join the opto-electronic assembly 261 to an electronic device (not shown).

In certain embodiments, an optical-electrical substrate may be arranged to provide interconnects to an opto-electronic IC having integrated optical input-output functionality.

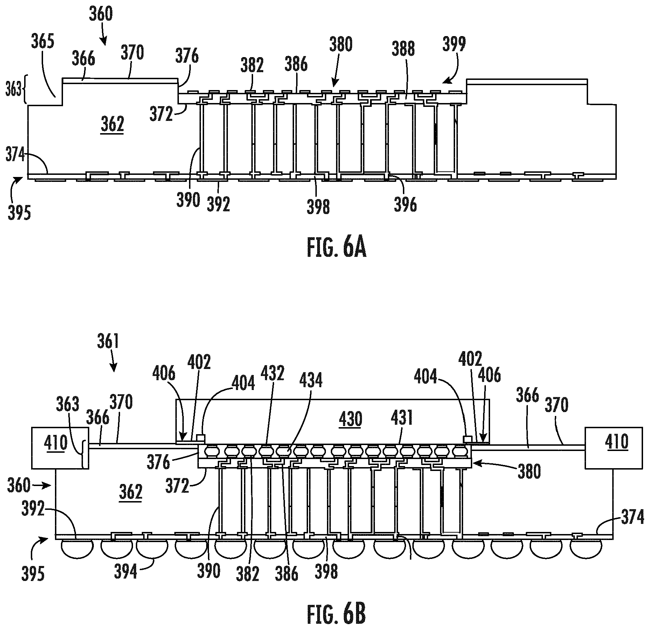

**FIG. 6A** is a side cross-sectional view of an optical-electrical substrate 360 according to one embodiment, with the optical-electrical substrate 360 including a glass body 362 having elevated portions 363 that each define an upper surface 370 and include one more glass optical waveguides ("waveguides") 366 proximate to the upper surface 370. The optical-electrical substrate 360 also includes a lower surface 374 as well as an intermediate surface 372 that is provided at an elevation between the upper and lower surfaces 370, 374. The elevated portions 363 are narrower in width than the remainder of the optical-electrical substrate, with a laterally offset portion of the intermediate surface 372 between the elevated portions 363 defining a cavity 399 that is suitable for receiving at least a portion of an IC (not shown). Additionally, peripheral recesses 365 positioned outset relative to the elevated portions 363 are suitable for receiving portions of optical connectors (not shown). Each elevated portion 363 includes a wall (or edge) 376 that extends between the upper surface 370 and the intermediate surface 372, and that laterally bounds a portion of the cavity 396. Within the cavity 399, at least one first redistribution layer 380 is supported by the intermediate surface 372, and includes electrical transmission elements 384 arranged within dielectric material (e.g., dielectric polymer) 388, as well as upper contact pads 382. The lower surface 374 also supports at least one second redistribution layer 395, which includes electrical transmission elements 386 arranged within dielectric material 388, with lower contact pads 392 further being arranged in contact with the at least one second redistribution layer 395. The optical-electrical substrate 360 further defines conductive vias 390 that extend from the intermediate surface 372 to the lower surface 374. In use, some conductive vias 390 may be used to carry data signals (e.g., to or from PICs), while other conductive vias 390 may be used to carry power and ground signals (e.g., to at least one IC), with the conductive vias 390 being coupled with electrical transmission elements 386 of the at least one second redistribution layer 395 and lower contact pads 392.

**FIG. 6B** is a side cross-sectional view of an opto-electronic assembly 361 including the optical-electrical substrate 360 of **FIG. 6A** arranged to receive optical connectors 410 and to provide interconnects to an IC 430 having integrated optical input-output capability. A lower surface 431 of the IC 430 includes centrally located electrical contact pads 432 and peripherally located waveguide regions 402, with the waveguide regions 402 each being coupled with an optical transducer 404. Each elevated portion 363 of the optical-electrical substrate 360 receives an optical connector 410 to promote optical coupling between the waveguides 366 and optical fibers (not shown) of the optical connector 410. Each elevated portion 363 of the optical-electrical substrate 360 is arranged to contact a portion of the IC 430 that includes at least some waveguide regions 402. The waveguide regions 402 overlap waveguides 366 of the optical-electrical substrate 360 at overlap regions 406 that promote optical coupling therebetween. Presence of the waveguides 366 of the optical-electrical substrate 360 at a position that is elevated relative to the at least one first redistribution layer 380 provides vertical space for bonding bumps 434 to be arranged between the optical-electrical substrate 360 and the IC 430. Electrical transmission elements 386 of the at least one first redistribution layer 380 may be used to convey electrical signals between the IC 430 and the conductive vias 390 that extend to the at least one second redistribution layer 395. Bonding bumps 394 are arranged against the lower contact pads 392 and may be used to join the opto-electronic assembly 361 to an electronic device (not shown).

In certain embodiments, passive alignment features may be defined in, or otherwise provided on, an optical-electrical substrate to permit one or more optical connectors to be aligned with the optical-electrical substrate, in order to enable optical communication between optical fibers of the optical connector(s) and glass optical waveguides of the optical-electrical substrate. In certain embodiments, passive alignment features may include grooves or trenches defined in an optical-electrical substrate, or may include features that protrude upward and/or outward from an optical-electrical substrate.

Several techniques may be employed to achieve precise placement of alignment features with respect to glass optical waveguides. In certain embodiments, alignment features can be formed in a glass substrate prior to the fabrication of the optical waveguides. Fiducials can then be used to fabricate glass optical waveguides (e.g., utilizing precision lithography steps) at the desired distance from the alignment features. In certain embodiments, laser ablation can form the desired slots, edges, surfaces, cavities or trenches in reference to the position of glass optical waveguides. In certain embodiments, a mask layer on the surface of a glass substrate may be lithographically defined and used to precisely define a laser ablation region.

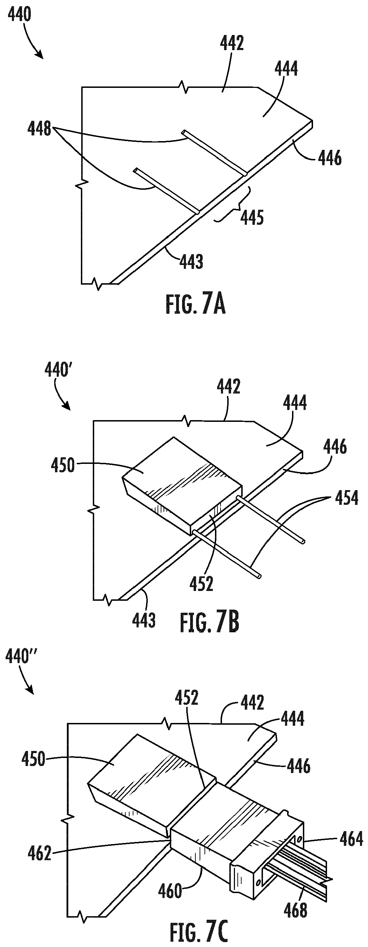

**FIG. 7A** is a perspective view of a portion of a first assembly 440 including an optical-electrical substrate ("substrate") 442 of a glass or glass-containing material that defines trenches 448 serving as passive alignment features to facilitate alignment of a multi-fiber connector (not show) to the substrate 442. The substrate 442 includes an upper surface 444 in which multiple glass optical waveguides (not shown) may be defined, wherein such glass optical waveguides may extend to a position between the trenches 448 without necessarily penetrating the entire substrate 442 to reach the bottom surface 443. The trenches 448 extend in a direction substantially perpendicular to an edge 446 of the substrate 442, and may be separated by a distance 445 equal to a distance between corresponding features (e.g., holes) defined in a multi-fiber connector. The trenches 448 may be defined by any suitable technique such as blade cutting, mechanical cutting, laser ablation or cutting, waterjet cutting, molding, etching, or the like. In certain embodiments, the trenches 448 may extend through less than an entire thickness of the substrate 442.

**FIG. 7B** is a perspective view of a portion of a second assembly 440' including the substrate 442 of **FIG. 7A** following addition of guide pins 454 and a cover or other retaining structure 450 to the upper surface 444 in order to retain the guide pins 454 in or against the trenches 448. In certain embodiments, the cover or other retaining structure 450 may be adhered to the upper surface 444, and may include an end face 452 that is substantially parallel to the edge 446 of the substrate 442. In certain embodiments, the cover or other retaining structure 450 may be either pre-molded or molded *in situ.* In certain embodiments, the cover or lid can be made of material (e.g. glass) that is matched in coefficient of thermal expansion to a material of the substrate 442.

**FIG. 7C** is a perspective view of a third assembly 440" including the substrate 442, guide pins (not shown), and cover or other retaining structure 450 of **FIG. 7B****,** following the mating of a multi-fiber connector 460 to the substrate 442, with the guide pins 454 (shown in FIG. 7B) received within corresponding guide holes 464 of the multi-fiber connector 460. The multi-fiber connector 460 includes multiple optical fibers 468 that may be terminated at an end face 462 of the multi-fiber connector 460. As shown, an end face 462 of the multi-fiber connector 460 may abut the end face 452 of the cover or other retaining structure 450, and ends of the optical fibers 468 may be arranged in optical communication with glass optical waveguides (not shown) arranged in or proximate to an upper surface 444 of the substrate 442.

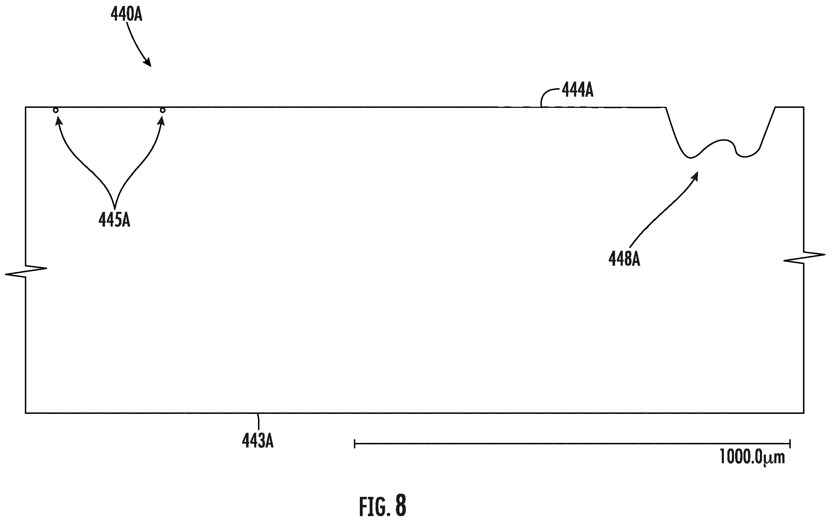

**FIG. 8** is an end cross-sectional view of a portion of a glass-based optical substrate ("substrate") 440A including ion exchange waveguides 445A arranged near an upper surface 444A of the substrate 440A and including a laser-formed trench 448A suitable for receiving a guide pin (not shown). As shown, the substrate 440A may have a thickness of less than about 1 mm (1000 µm) between the upper surface 444A and a lower surface 443A, and the trench 448 may extend through less than the entire thickness of the substrate 440A.

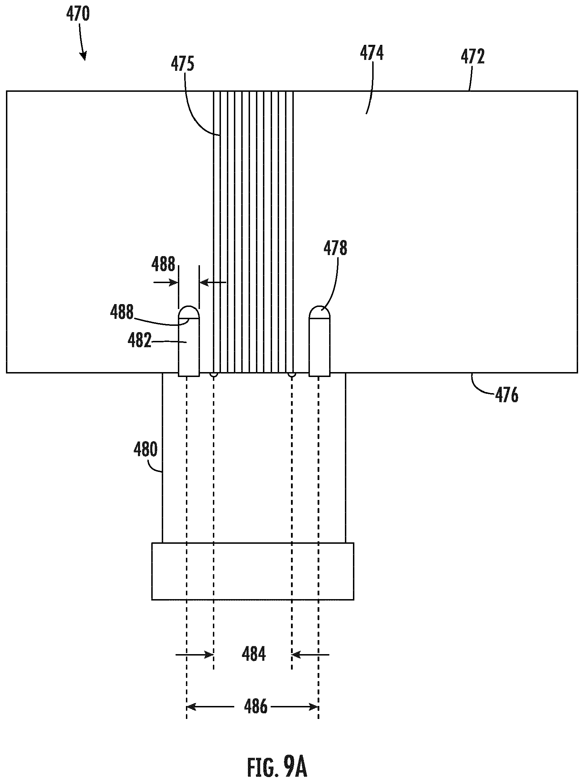

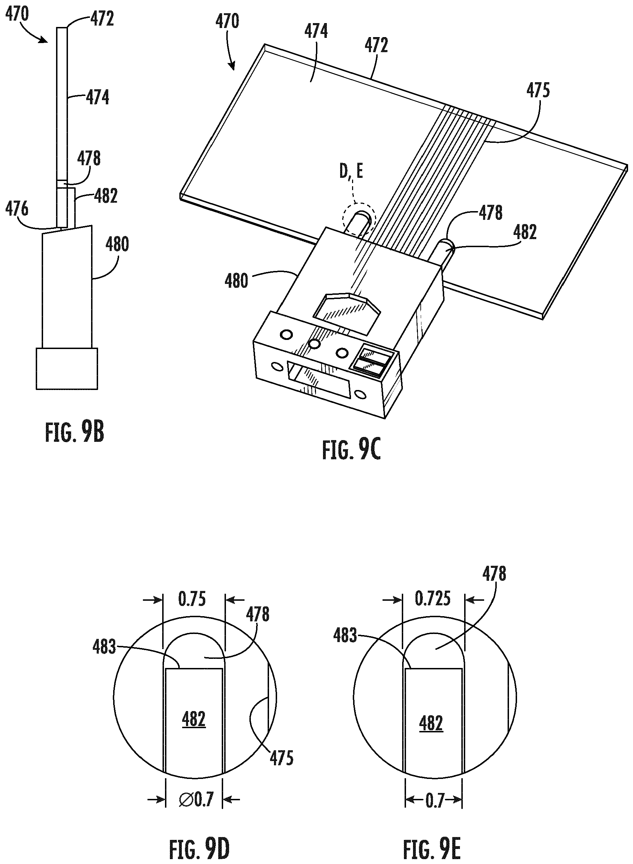

**FIG. 9A-9C** provide top plan, side elevational, and perspective views, respectively, of a multi-fiber optical connector 480 having protruding alignment pins 482 mated with a glass or glass-based optical substrate ("substrate") 470, with the alignment pins 482 received by slots 478 defined in the substrate 470. The substrate 470 includes an upper surface 474, a front edge 476, and a rear edge 472, and includes multiple glass optical waveguides ("waveguides") 475 extending between the front edge 476 and the rear edge 472 at a position between the slots 478. The slots 478 have a center-to-center spacing 486 (e.g., 4.6 mm in one embodiment) that is substantially the same as a corresponding center-to-center spacing of the alignment pins 482, while the slots 478 may have a length that is greater than a length by which the alignment pins 482 extend forward from the multi-fiber optical connector 480. In certain embodiments, the slots 478 have a width 488 that may be substantially the same as, or slightly greater than, a diameter of each alignment pin 482. The outermost two waveguides 475 may be distance apart by a width 484 (e.g., 2.75 mm in one embodiment) that is smaller than the center-to-center spacing 486 between the slots 478.

**FIGS. 9D** and **9E** provide top plan views of a magnified portion of the glass-based optical substrate 470 and one alignment pin 482 of the multi-fiber optical connector 480 as shown in **FIGS. 9A-9C****,** with the same diameter (0.7 mm) for the alignment pin 482 in each instance but different dimensions for the slot 478 (i.e., 0.75 mm in **FIG. 9D** and 0.725 mm in **FIG. 9E**) according to two implementations. In certain embodiments, a lateral gap of 25 microns on one or both sides of an alignment pin 482 may be provided to accommodate insertion of the alignment pin 482 into the slot 478, but any suitable gap may be provided.

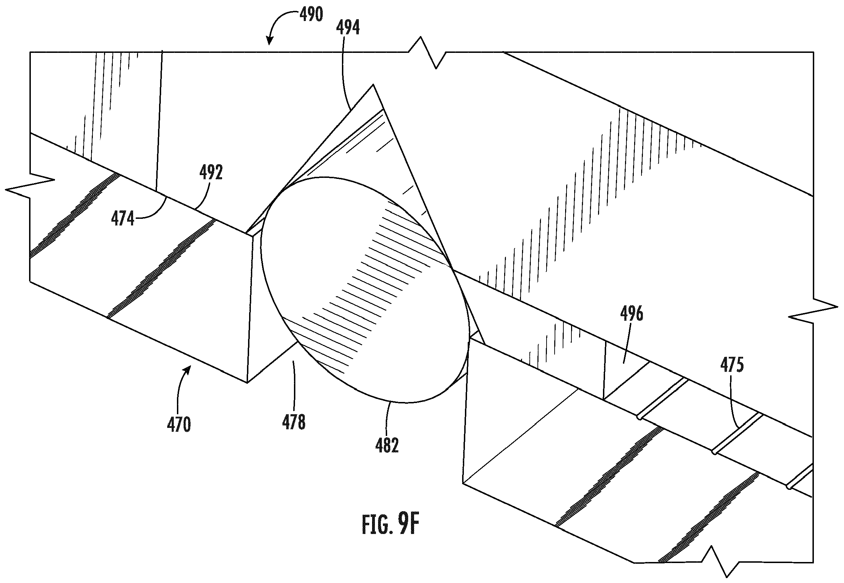

**FIG. 9F** is a perspective view of a portion of an assembly including the glass-based optical substrate 470 and the multi-fiber optical connector 480 as shown in **FIGS. 9A-9C****,** with the addition of a cover 490 defining a V-groove 494 that receives an alignment pin 482 of the multi-fiber optical connector 480, such that the alignment pin 482 is arranged in and between the slot 478 and the V-groove 494. As shown, a lower surface 492 of the cover 490 is arranged to contact the upper surface 474 of the glass-based optical substrate 470. In certain embodiments, a recess 496 may be defined in the cover 490 over the glass optical waveguides 475 defined in the glass-based optical substrate 470.

In certain embodiments, slots defined in a glass-based optical substrate may have a reduced width relative to a lateral dimension (e.g., diameter) of alignment pins of an optical connector arranged to cooperate with the glass-based optical substrate.

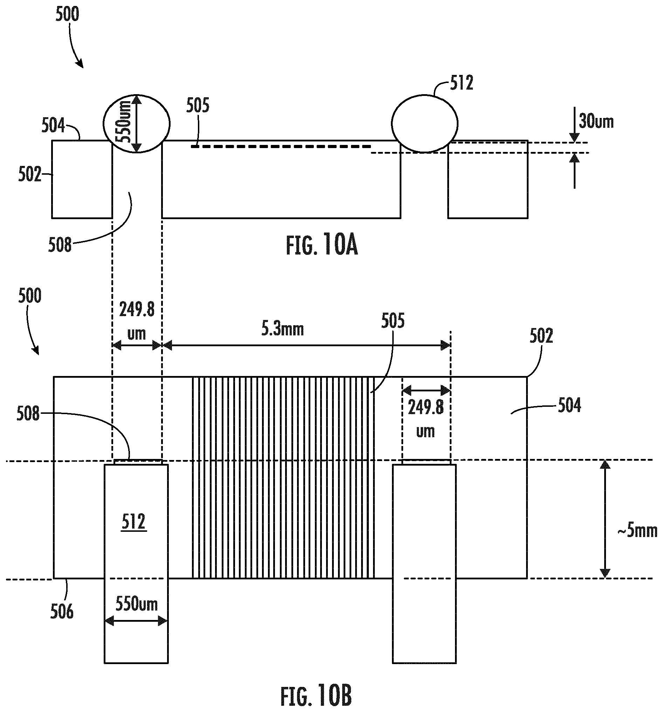

**FIGS. 10A** and **10B** provide end elevational and top plan views, respectively, of an assembly 500 including alignment pins 512 of an optical connector (not shown) arranged in contact with an upper surface 504 of a glass-based optical substrate ("substrate") 502, with lower portions of the alignment pins 512 extending into slots 508 defined in the substrate 502. The substrate 502 defines a plurality of glass optical waveguides ("waveguides") 505 proximate to the upper surface 504, with the waveguides 505 being arranged between the slots 508, and the slots 508 extending generally perpendicular to an edge 506 of the substrate 502. The slots 508 have a reduced width relative to a width dimension (e.g., diameter) of the alignment pins 512. In one embodiment, each slot 508 may have a width that is from 30% to 90%, or from 40% to 75%, or from 50% to 65%, of a width dimension of each alignment pin 512. As shown, each slot 508 may have a width of 249.8 µm and each alignment pin 512 may have a width dimension (e.g., diameter) of 550 µm. Additionally, each alignment pin 512 may extend a short distance (e.g., less than 100 µm, or 20 µm to 50 µm, or about 30 µm) downward into a corresponding slot 508), and each slot 508 may have a length of about 5 mm.

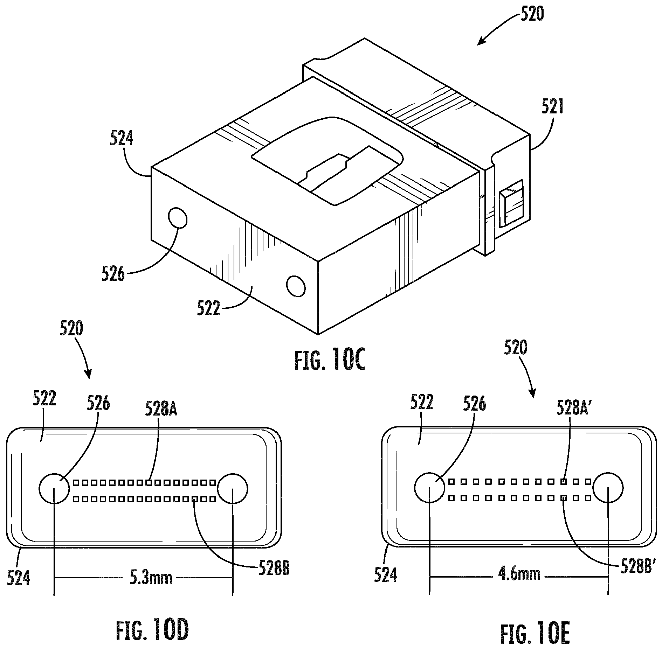

**FIG. 10C** is a perspective view of a ferrule portion 520 of a multi-fiber optical connector useable with the alignment pins 512 and the substrate 502 of FIGS. 10B and 10C. The ferrule portion 520 includes a body 524, a rear end 521, a front end 522, and alignment holes 526 for receiving alignment pins (not shown) extending through the body 524 between the rear end 521 and the front end 522. Multiple bores (not shown) of any suitable number and any suitable pattern may extend through the front end 522 to expose terminated and polished ends of optical fibers of the connector.

**FIGS. 10D** and **10E** are end elevational views of the ferrule portion of **FIG. 10C** with different numbers of optical fiber bores and different spacing between alignment holes 526. In **FIG. 10D****,** two rows of optical fiber bores 528A, 528B each having sixteen bores are provided between alignment holes 526 having a center-to-center spacing of 5.3 mm. In FIG. 10D, two rows of optical fiber bores 528A', 528B' each having twelve bores are provided between alignment holes 526 having a center-to-center spacing of 4.6 mm. In various implementations, any suitable number of optical fiber bores and any suitable spacing between alignment holes may be provided. Although multiple rows of optical fiber bores are shown in **FIGS. 10C** and **10D****,** it is to be noted that in certain embodiments only a single row of optical fiber bores may be populated with optical fibers and/or used to interface with glass optical waveguides integrated within a glass-based optical substrate (e.g., including electrically conductive vias to serve as an optical-electrical substrate) as disclosed herein, since such a substrate may have glass optical waveguides arranged at one depth therein.

In certain embodiments, a glass body of a glass-based optical substrate (which may include electrically conductive vias to constitute an optical-electrical substrate) may include a cavity that defines an intermediate surface arranged at an elevation between upper and lower surfaces, with the intermediate surface being arranged to receive an electronic IC. To promote space-efficient packaging and reduce the length of signal conduits and/or promote efficient optical coupling, it may be desirable to reduce distances between components (e.g., PICs and electronic ICs) on a glass-based optical substrate. Techniques for forming cavities in glass-based optical substrates and accommodating reduced distances between components according to certain embodiments will now be described, including techniques for achieving precision depths desirable to promote effective evanescent and edge coupling.

For effective edge coupling, the waveguide on a PIC (or optical ASIC) should desirably be aligned to within about 1 µm relative to a glass optical waveguide defined in a glass substrate. To adjust the vertical height, certain embodiments provide for a SiP PIC to be recessed into a cavity within the glass. Glass optical waveguides may be defined proximate to an upper surface of a substrate, and an etch-resistant mask may be deposited and lithographically defined by applying a photoresist process to open windows in the etch-resistant mask. Thereafter, an acid etch (e.g., HF) may be used to isotropically removes glass not protected by the etch-resistant mask. After etching is complete, the etch-resistant mask may be removed, and a PIC or electronic IC (e.g., ASIC) with optical input/output may be placed in the well of a cavity to optically couple to the glass optical waveguides near the upper surface of the glass. Coupling types that may be used include evanescent coupling, edge coupling, or grating coupling. In such types of coupling, a precise cavity depth is desirable for effective coupling and can be achieved by acid etching. However, the isotropic nature of acid etching tends to create rounded edges around the cavity perimeter resulting in a gap between a PIC and glass optical waveguides. For edge coupling, reducing this gap will improve optical coupling. To do so, one process may involve scanning a short pulsed laser (with either a Gaussian or Bessel beam) around the outer edge of a window proximate to a mask (e.g., photoresist) boundary. Above a certain optical damage threshold, the exposed glass becomes more susceptible to acid etching, and therefore etches at a faster rate. Such anisotropic etching can be used to create a sharp, 90 degree side wall edge to reduce the gap between a PIC and glass optical waveguides.

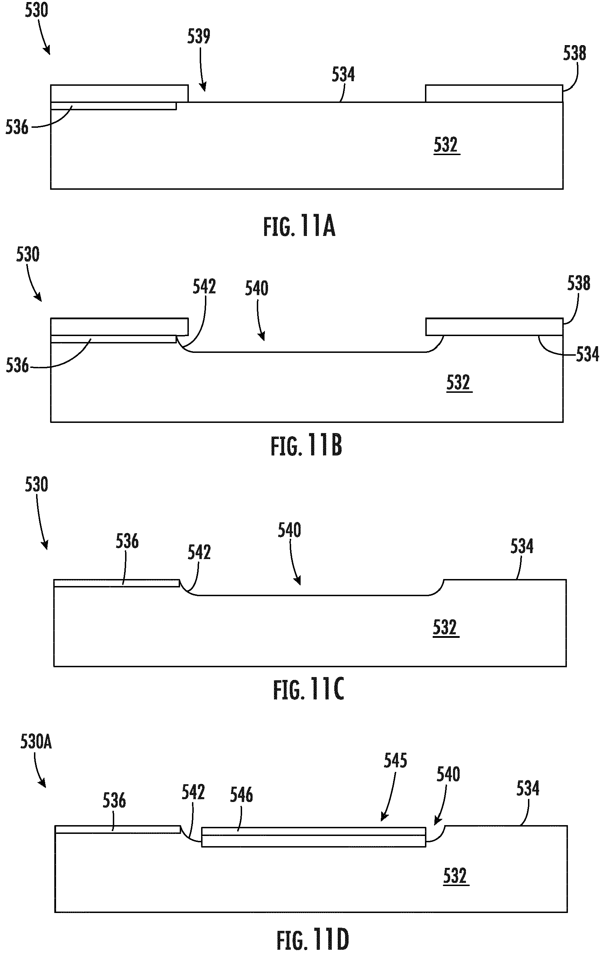

**FIGS. 11A-11D** illustrate steps in forming a cavity having relatively large-radius transitions in an upper portion of a glass-based optical substrate ("substrate") 532 having glass optical waveguides ("waveguides") 536 arranged proximate to an upper surface 534 thereof. In **FIG. 11A****,** an assembly 530 includes an etch-resistant mask 538 arranged (e.g., patterned) over portions of the upper surface 534 (including the waveguides 536) of the substrate 532, with a window 539 being defined in the etch-resistant mask 538 to expose a portion of the upper surface 534. **FIG. 11B** shows the assembly 530 of FIG. **11A****,** following removal of material from the substrate 532 to form a cavity 540, by application of an etchant to the upper surface 534 of the substrate 532 exposed by the window 539. As shown, the cavity 540 includes transitions 542 of a relatively large radius between a floor of the cavity 540 and the upper surface 534 of the substrate 532. **FIG. 11C** shows the assembly 530 of **FIG. 11B** following removal of the etch-resistant mask 538. **FIG. 11D** shows an assembly 530A formed by mounting of an IC 545 having optical input-output capability (e.g., embodied in a PIC or an ASIC having optical inputs and outputs) in the cavity 540. The IC 545 includes an integrated waveguide region 546 arranged substantially coplanar with waveguides 536 defined in the substrate 532. Due to the presence of relatively large radius transitions 542 between a floor of the cavity 540 and the upper surface 534, however, a horizontal distance between the waveguides 536 of the substrate 532 and the waveguide region 546 of the IC 545 may be greater than would be desirable to promote efficient optical coupling and reduce space utilization on the substrate 532. For ease of illustration, solder regions and redistribution layers that may be provided between the IC 545 and the substrate 552, as well as conductive vias that may be provided in the substrate 532, are omitted.

In certain embodiments, one or more properties (e.g., shape, depth, position, etc.) of transitions between an upper surface and a cavity floor of a glass-based optical substrate may be adjusted or otherwise affected by locally adjusting properties of substrate material prior to etching, such as by impingement of laser emissions in or on regions of the substrate.

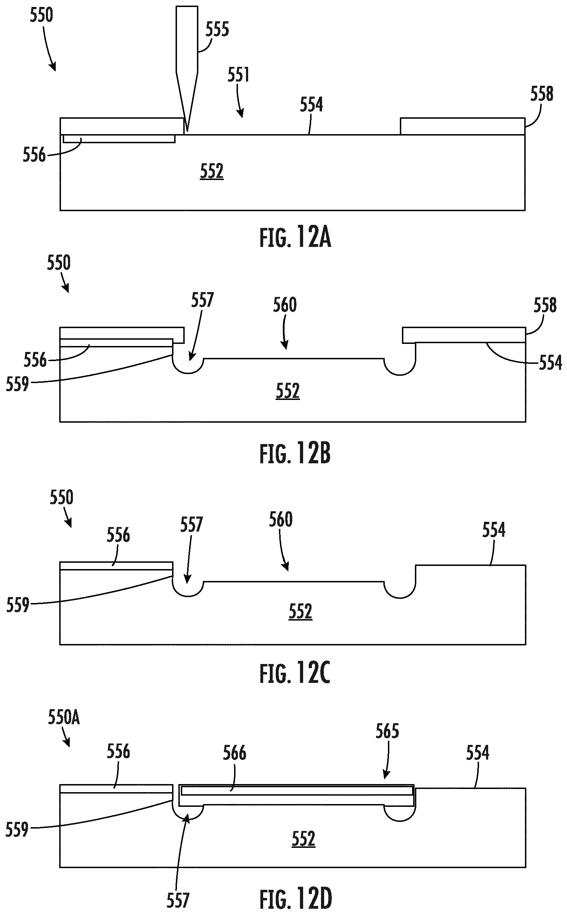

**FIGS. 12A-12D** illustrate steps in forming a cavity 560 (shown in **FIGS. 12B-12D**) in an upper portion of a glass-based optical substrate ("substrate") 552 having glass optical waveguides ("waveguides") 556 arranged proximate to an upper surface 554 thereof, with the cavity 560 having increased depth regions 557 at transitions between the upper surface 554 of the substrate 552 and a floor of the cavity 560. In **FIG. 12A****,** an assembly 550 includes an etch-resistant mask 558 arranged (e.g., patterned) over portions of the upper surface 554 (including the waveguides 556) of the substrate 552, with a window 551 being defined in the etch-resistant mask 558 to expose a portion of the upper surface 554. Impingement of a laser beam 555 on portions of the substrate 552 (e.g., proximate to lateral edges of the window 551 defined in the etch-resistant mask 558) results in formation of laser damage regions in the substrate 552 that may be preferentially etched in exposure to an etching composition. **FIG. 12B** shows the assembly 550 of **FIG. 12A****,** following removal of material from the substrate 552 to form the cavity 560, by application of an etchant to the upper surface 554 of the substrate 552 exposed by the window 551 (shown in **FIG. 12A**)**.** As shown, the cavity 560 includes increased depth regions 557 at transitions between a floor of the cavity 560 and the upper surface 554 of the substrate 552, resulting in a more vertical wall 559 (compared to FIGS. 11B-11D) that laterally bounds the cavity 560. FIG. 12C shows the assembly 550 of FIG. 12B following removal of the etch-resistant mask 558. FIG. 12D shows an assembly 550A formed by mounting of an IC 565 having optical input-output capability (e.g., embodied in a PIC or an ASIC having optical inputs and outputs) in the cavity 560. The IC 545 includes an integrated waveguide region 566 arranged substantially coplanar with waveguides 556 defined in the substrate 552. Due to the presence of the more vertical wall 559 laterally bounding the cavity 560, a horizontal distance between the waveguides 556 of the substrate 552 and a waveguide region 566 of the IC 565 is reduced relative to the arrangement shown in **FIG. 11D****.**

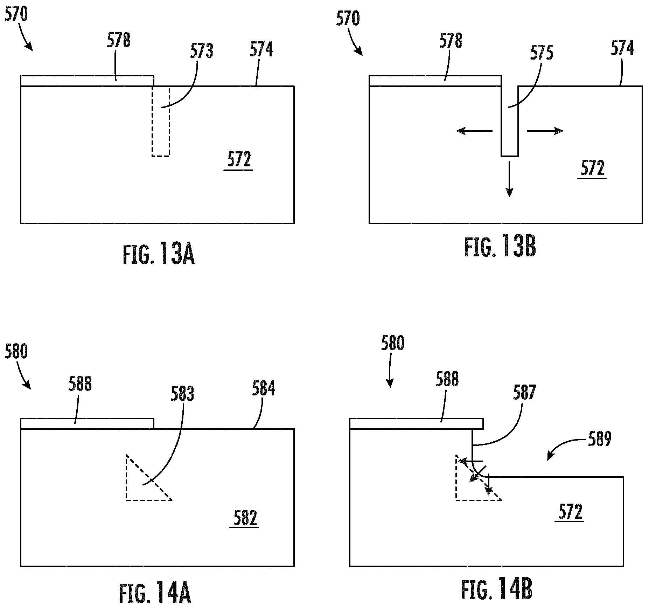

**FIG. 13A** is a side cross-sectional view of an assembly 570 including a glass-based optical substrate ("substrate") 572 with an etch-resistant mask 578 arranged on a portion of an upper surface 574 thereof, following formation of a generally rectangular laser damage region 573 in the interior of the substrate 572 to promote preferential etching of glass material from the substrate 572. Depth of the laser damage region 573 may be adjusted to altering a focal depth of laser emissions within the substrate 572. **FIG. 13B** shows the substrate 572 of **FIG. 13A** following formation of a generally rectangular cavity 575 in an interior of the substrate 572 following exposure of the upper surface 574 of the substrate 572 to an etchant, whereby the laser damage region 573 is etched more quickly than the remainder of the substrate. Arrows proximate to the generally rectangular cavity 575 depict the direction of subsequent etching if the substrate and the generally rectangular cavity 575 remain exposed to an etchant after the cavity 575 is formed.

**FIG. 14A** is a side cross-sectional view of an assembly 580 including a glass-based optical substrate ("substrate") 582 with an etch-resistant mask 588 arranged on a portion of an upper surface 584 thereof, following formation of a generally triangular laser damage region 583 in the interior of the substrate 582 to promote preferential etching of a glass material from the substrate 582. **FIG. 14B** shows the assembly 580 of **FIG. 14A** following initial formation of a cavity 589 in an interior of the substrate 582 (e.g., by etching with an etchant) just prior to exposure of the laser damage region 583 to the etchant, with a generally vertical wall portion 587 bounding an upper part of the cavity 589. Presence of the laser damage region 583 may affect the final shape and dimensions of the cavity 589 defined in the substrate 582.

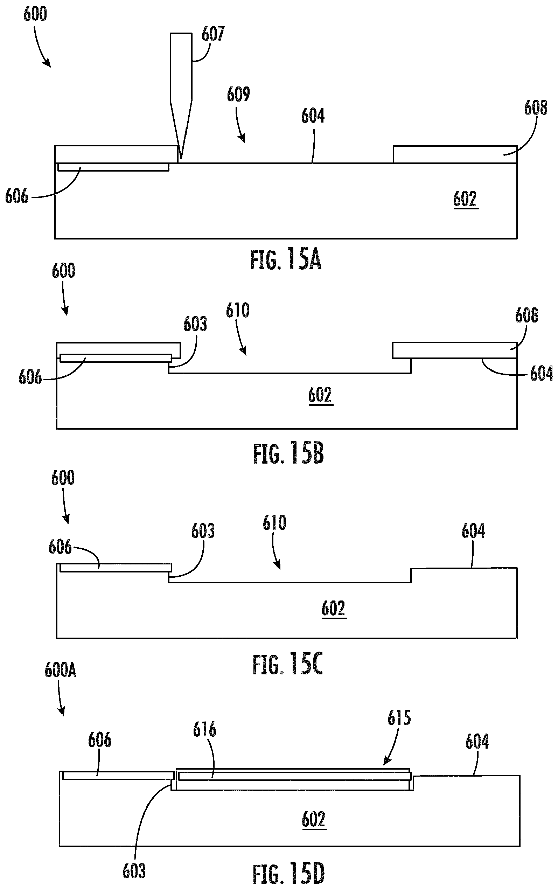

**FIGS. 15A-15D** illustrate steps in forming a cavity 610 (shown in FIGS. 15B-15D) in an upper portion of a glass-based optical substrate ("substrate") 602 having glass optical waveguides ("waveguides") 606 defined along an upper surface 604 thereof, with the cavity 610 being laterally bounded by having a generally vertical sidewall 603.

In **FIG. 15A****,** an assembly 600 includes an etch-resistant mask 608 arranged (e.g., patterned) over portions of the upper surface 604 (including the waveguides 606) of the substrate 602, with a window 609 being defined in the etch-resistant mask 608 to expose a portion of the upper surface 604. Impingement of a laser beam 607 on portions of the substrate 602 (e.g., proximate to lateral edges of the window 609 defined in the etch-resistant mask608) results in formation of laser damage regions in the substrate 602 that may be preferentially etched in exposure to an etching composition. **FIG. 15B** shows the assembly 600 of **FIG. 15A****,** following removal of material from the substrate 602 to form a cavity 610, by application of an etchant to the upper surface 604 of the substrate 602 exposed by the window 609 (shown in **FIG. 15A**)**.** As shown, the cavity 610 is laterally bounded by the generally vertical sidewall 603 at a transition between the upper surface and a floor of the cavity 610. **FIG. 15C** shows the assembly 600 of **FIG. 15B** following removal of the etch-resistant mask 608. **FIG. 15D** shows an assembly 600A formed by mounting of an IC 615 having optical input-output capability (e.g., embodied in a PIC or an ASIC having optical inputs and outputs) in the cavity 610. The IC 615 includes an integrated waveguide region 616 arranged substantially coplanar with waveguides 606 defined in the substrate 602. Due to the presence of the generally vertical sidewall 603 laterally bounding the cavity 610, a horizontal distance between the waveguides 606 of the substrate 602 and a waveguide region 616 of the IC 615 is reduced relative to the arrangement shown in **FIG. 11D****.**

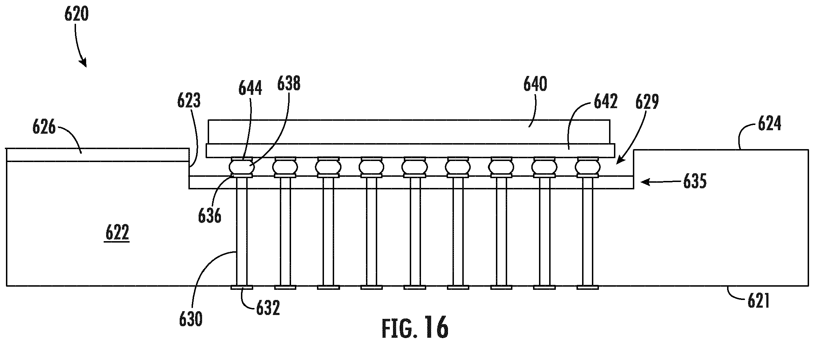

**FIG. 16** is a side cross-sectional view of an assembly 620 including an IC 640 with integrated optical input/output capability (e.g., combining ASIC and PIC utility), and with optical waveguide region 642 along a lower surface of the IC 640, mounted in a cavity 629 of an optical-electrical substrate ("substrate") 622 according to one embodiment. As shown, the optical waveguide region 642 of the IC 640 is substantially coplanar with glass optical waveguides ("waveguides") 626 that are arranged along an upper surface 624 of the substrate 622. The cavity 629 is laterally bounded by a sidewall 623. The depth of the cavity 629, as well as a combined height of at least one redistribution layer 635, electrical contact pads 636, 644, and bonding bumps 638 arranged in the cavity 629, may be selected to promote alignment (and edge coupling) between the waveguides 626 and the optical waveguide region 642. Conductive vias 630 may extend through the substrate 622 to interconnect electrical contact pads 636 associated with the redistribution layer 635 and electrical contact pads 632 arranged on a lower surface 621 of the substrate 622. It is to be noted that the redistribution layer 635 and conductive vias 630 are shown in simplified schematic form, since the redistribution layer 635 would typically include electrical transmission elements and serve to accommodate differences in pitch between the bonding bumps 638 in the cavity 629 and the contact pads 632 on the lower surface 621 of the substrate 622.

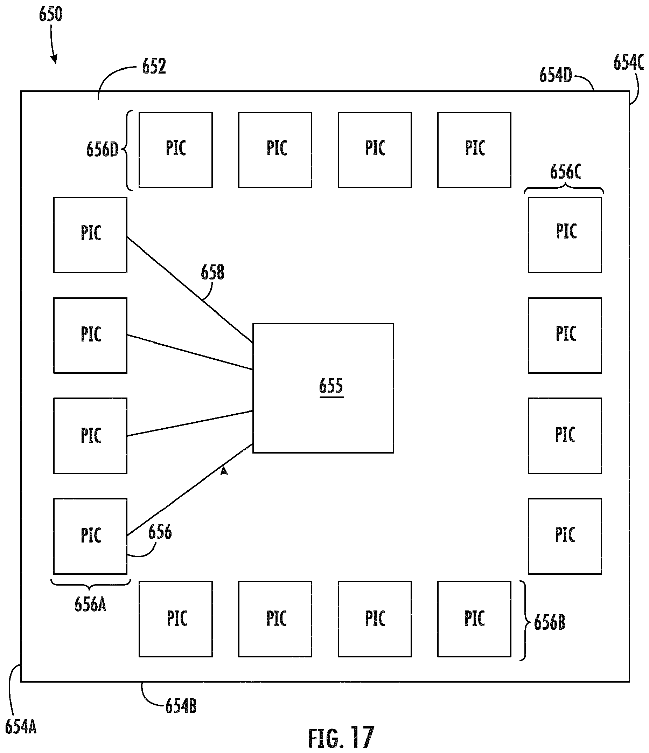

**FIG.** 17 is a schematic top plan view of an optical-electrical substrate ("substrate") 650 supporting a centrally located electronic IC 655 and four peripherally located groups 656A-656D of optical transceiver elements (e.g., PICs) 656, showing a potential layout for glass optical waveguide groups 658 between transceiver elements 656 and the IC 655. In one embodiment, each glass optical waveguide group 658 may include sixty-four differential coplanar waveguides having a pitch of about 200 µm at the optical transceiver elements 656 that reduces to a pitch of about 100 µm at the IC 655. As shown, the substrate 650 is rectangular in shape with four edges 654A-654D, with each optical transceiver group 656A-656D being arranged parallel to, and proximate to, a different edge 654A-654D of the substrate 650. A total of sixteen optical transceiver elements 656, organized into four groups 656A-656D, are illustrated. In one implementation, the IC 655 may be embodied in an Ethernet ASIC of 51 Tbps, with sixty-four coplanar waveguide lines of 100 Gbps connecting each transceiver element 656 to the ASIC.

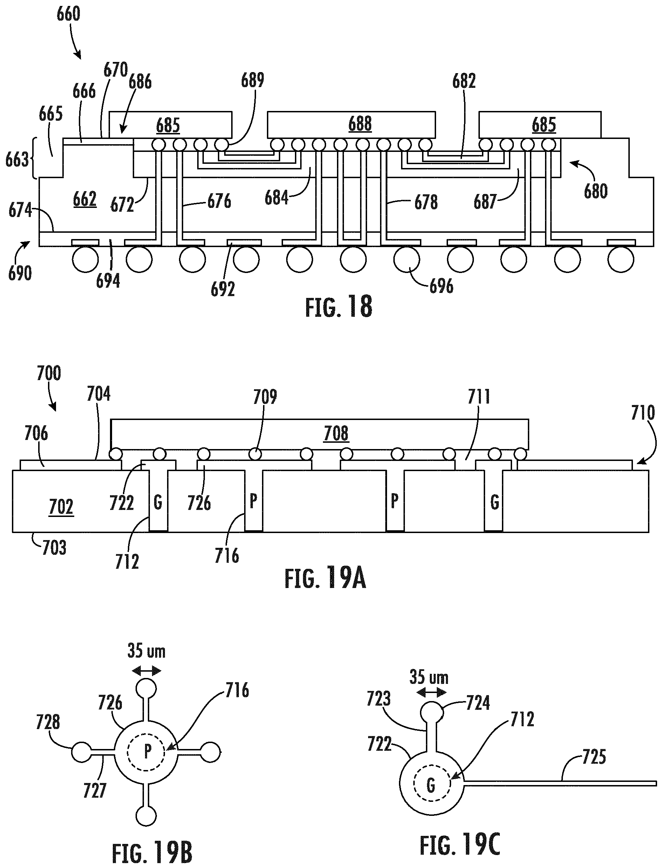

**FIG. 18** is a side cross-sectional view of an opto-electronic assembly 660 including an optical-electrical substrate ("substrate") 662 according to one embodiment, with conductive vias 676, 678 arranged to conduct power and ground signals vertically through the substrate 662, and with electrical transmission elements 682 of at least one first redistribution layer 680 arranged to conduct signals laterally between multiple PICs 685 and an electronic IC 688. The substrate 662 includes a lower surface 674 as well as an intermediate surface 672 that is provided at an elevation between upper and lower surfaces 670, 674with the upper surface 672 arranged at the top of elevated portions 663 of the substrate 662. The elevated portions 663 are narrower in width than the remainder of the substrate 662, with a laterally offset portion of the intermediate surface 672 defining a cavity that receives the first redistribution layer 680 and bonding bumps 689 for mounting the PICs 685 and the IC 688. Additionally, peripheral recesses 665 positioned outset relative to the elevated portions 663 are suitable for receiving portions of optical connectors (not shown). Each elevated portion 663 includes a wall (or edge) that extends between the upper surface 670 and the intermediate surface 672, and that laterally bounds the at least one first redistribution layer 680 supported by the intermediate surface 672. The at least one first redistribution layer 680 includes electrical transmission elements 684 arranged within dielectric material (e.g., dielectric polymer) 687. The lower surface 674 also supports at least one second redistribution layer 690, which includes dielectric material 694 and lower electrical contact pads 692. The substrate 662 defines peripheral conductive vias 676 coupled to the PICs 685 and central conductive vias 678 coupled to the IC 688, with the foregoing conductive vias 676, 678 extending from the intermediate surface 672 to the lower surface 674. In use, the peripheral conductive vias 676 may be used to carry power and ground signals to the PICs 685, while the central conductive vias 678 may be used to carry power and ground signals to the IC 688. Optical signals may be conducted between glass optical waveguides 666 (defined in the substrate 662 proximate to the upper surface 670) and the PICs 685 by optical coupling (e.g., evanescent / adiabatic coupling) at overlap regions 686. Electrical signals may be conducted between the PICs 685 and the IC 688 by electrical transmission elements 682 of the at least one first redistribution layer 680. Bonding bumps 696 coupled to the lower electrical contact pads 692 may be used to join the opto-electronic assembly 660 to an electronic device (not shown). It is to be appreciated that additional thru-glass conductive vias for signal routing (e.g., ASIC management, Ethernet lines, etc.) are not shown, but may be present in an operative device.

**FIG. 19A** is a side cross-sectional view of a portion of an opto-electronic assembly 700 including an optical-electrical substrate ("substrate") 702 according to one embodiment, with conductive vias 712, 716 (also referred to as ground vias 712 and power vias 716) arranged to conduct power and ground signals vertically through the substrate 702 (e.g., from an intermediate surface 706 to a lower surface 703), and with fan-out electrical contacts 722, 726 (also referred to as fan-out ground contacts 722 and fan-out power contacts 726, or more generally electrically transmission elements 722, 726) arranged between the substrate 702 and an electronic IC 708. At least one redistribution layer 710 including electrical transmission elements 704 and dielectric material 711 is also provided, with bonding bumps 709 providing electrical communication between the IC 708 and the fan-out electrical contacts 722, 726 as well as the electrical transmission elements 704.

**FIG. 19B** is a top plan view of a fan-out power contact 726 arrangeable on the intermediate surface 706 of the substrate 702 of **FIG. 19A****.** The fan-out power contact 726 includes multiple branches 727 and terminal portions 728 that are laterally displaced relative to a power via 716 registered with the fan-out power contact 726. The fan-out power contact 726 may serve to distribute power to multiple regions of the IC 708 of **FIG. 19A****,** without requiring an unduly large number of power vias 716 to be defined through the substrate 702.

**FIG. 19C** is a top plan view of a fan-out ground contact 722 arrangeable on the intermediate surface 706 of the opto-electronic assembly 700 of **FIG. 19A****.** The fan-out ground contact 722 includes an IC branch 723 and terminal portion 724, as well as a transmission branch line 725, that are laterally displaced relative to a ground via 712 registered with the fan-out ground contact 722. The IC branch 723 and terminal portion 724 may aid in distributing a ground to one or more regions of the IC 708 of FIG. 19A without requiring an unduly large number of ground vias 712 to be defined through the substrate 702, while the transmission line branch 725 may provide a ground for a PIC or other device (not shown).

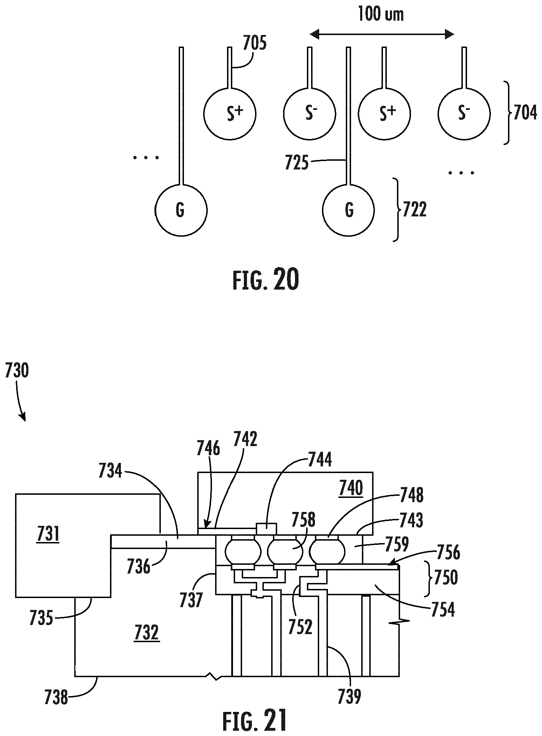

**FIG. 20** is top plan view of one arrangement of electrical transmission elements 704, 722 (i.e., signal contacts 704 and ground contacts 722) and transmission lines (i.e., signal transmission lines 705 and transmission branch lines 725) of a redistribution layer useable with an optical-electrical substrate as disclosed herein. The signal contacts 704 may be arranged in a row that is arranged outboard relative to the ground contacts 722. The signal contacts 704 may be registered with an arranged in conductive electrical communication with one or more signal vias (not shown) extending through an optical-electrical substrate (not shown), and the ground contacts 722 may be registered with and arranged in conductive electrical communication with one or more ground vias extending through the same optical-electrical substrate, such that the signal contacts 704 define an outer row of signal contacts and the ground contacts 722 define an inner row of ground contacts.

In certain embodiments, a PIC may provide electronic IC functionality and may be mounted on or over an optical-electrical substrate, with optical coupling between waveguide regions of the PIC and glass optical waveguides of the substrate, and with electrical coupling between electrical contact pads of the PIC and electrical contact pads of at least one redistribution layer of the substrate.

**FIG. 21** is a side cross-sectional view of a portion of an opto-electronic assembly 730 according to one embodiment, including an optical-electrical substrate ("substrate") 732 receiving an optical connector 731 and a PIC 740 having integrated electronic IC functionality (e.g., fabricated according to a BiCMOS process). The substrate 732 defines an upper surface 734, a lower surface 738, and an intermediate surface 735 that is provided at an elevation between the upper and lower surfaces 734, 738. A first wall (or edge) 737 extends vertically between the upper surface 734 and the intermediate surface 735, and bounds a cavity that contains at least one redistribution layer 750. One or more (typically multiple) glass optical waveguides ("waveguides") 736 are defined in the substrate 732 proximate to the upper surface 734, and serve to provide optical connections between the optical connector 731 (e.g., a multi-fiber connector) and waveguide regions 742 arranged along a lower surface 743 of the PIC 740. The waveguide regions 742 are coupled to the glass optical waveguides 736 at an overlap region 746, and are optically coupled to optical transducers 744. The substrate 732 includes multiple electrically conductive vias 739 extending between the intermediate surface 735 and the lower surface 738, with at least some of the electrically conductive vias 739 being coupled with electrical transmission elements 752 arranged within dielectric material 754 in the at least one redistribution layer 750. Upper contact pads 756 of the at least one redistribution layer 750 are electrically coupled with lower contact pads 748 of the PIC 740 via bonding bumps 758 that are encased in an encapsulant material 759. In certain embodiments, the substrate 732 is fabricated of a single member of glass or glass-containing material. In other embodiments, the substrate 732 may be fabricated of multiple pieces of glass, or one piece of glass and a piece of other material, and bonded along an interface to form the substrate 732.

In certain embodiments, a PIC may include one or more through-silicon vias and serve as an interposer between an optical-electrical substrate and an electronic IC, with optical and electrical coupling between the PIC and the optical-electrical substrate.

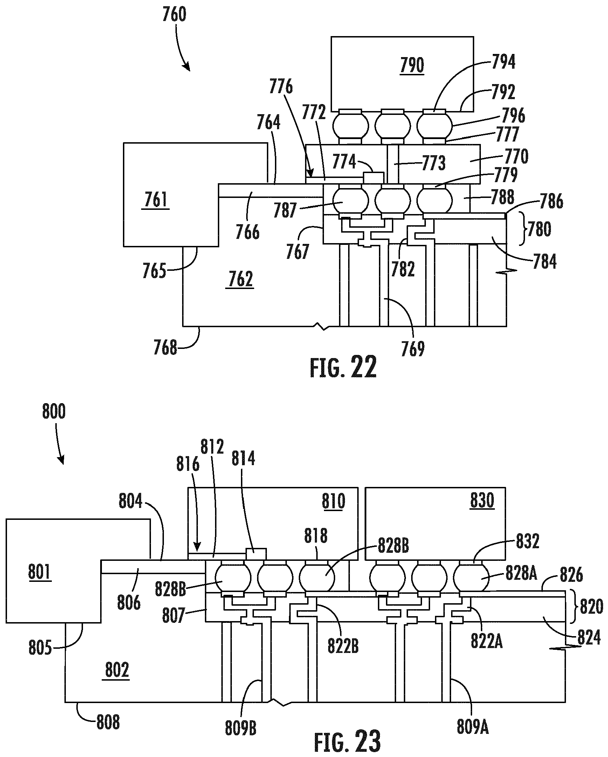

**FIG. 22** is a side cross-sectional view of a portion of an opto-electronic assembly 760 according to one embodiment, including an optical-electrical substrate ("substrate") 762 receiving an optical connector 761 and a PIC 770 having at least one through-silicon via 773, with the PIC 770 serving as an interposer between the substrate 762 and an electronic IC 790. The substrate 762 defines an upper surface 764, a lower surface 768, and an intermediate surface 765 that is provided at an elevation between the upper and lower surfaces 764, 768. A first wall (or edge) 767 extends vertically between the upper surface 764 and the intermediate surface 765, and bounds a cavity that contains at least one redistribution layer 780. One or more (typically multiple) glass optical waveguides ("waveguides") 766 are defined in the substrate 762 proximate to the upper surface 764, and serve to provide optical connections between the optical connector 761 (e.g., a multi-fiber connector) and waveguide regions 772 arranged along a lower surface of the PIC 770. The waveguide regions 772 are coupled to the glass optical waveguides 766 at an overlap region 776, and are optically coupled to optical transducers 774 of the PIC 770. The substrate 762 includes multiple electrically conductive vias 769 extending between the intermediate surface 765 and the lower surface 768, with at least some of the electrically conductive vias 769 being coupled with electrical transmission elements 782 arranged within dielectric material 784 in the at least one redistribution layer 780. Upper contact pads 786 of the at least one redistribution layer 780 are electrically coupled with lower contact pads 779 of the PIC 770 via bonding bumps 787. Similarly, upper contact pads 777 of the PIC 770 are electrically coupled with lower contact pads 794 of the IC 790 via bonding bumps 796, with the through-silicon via 773 creating an electrically conductive path from the IC 790 through the PIC 770 to the at least one first redistribution layer 780.

In certain embodiments, an optical-electrical substrate may be arranged to support one or more PICs as well as an electronic ICs that are laterally adjacent to the PICs.

**FIG. 23** is a side cross-sectional view of a portion of an opto-electronic assembly 800 including an optical-electrical substrate 802 receiving an optical connector 801 as well as a PIC 810 and an electronic IC 830 that is laterally adjacent to the PIC 810. The substrate 802 defines an upper surface 804, a lower surface 808, and an intermediate surface 805 that is provided at an elevation between the upper and lower surfaces 804, 808. A first wall (or edge) 807 extends vertically between the upper surface 804 and the intermediate surface 805, and bounds a cavity that contains at least one redistribution layer 820. One or more (typically multiple) glass optical waveguides ("waveguides") 806 are defined in the substrate 802 proximate to the upper surface 804, and serve to provide optical connections between the optical connector 801 (e.g., a multi-fiber connector) and waveguide regions 812 arranged along a lower surface of the PIC 810. The waveguide regions 812 are coupled to the glass optical waveguides 806 at an overlap region 816, and are optically coupled to optical transducers 814 of the PIC 810. The substrate 802 includes multiple electrically conductive vias 809A, 809B (i.e., central conductive vias 809A and peripheral conductive vias 809B) extending between the intermediate surface 805 and the lower surface 808, with at least some of the electrically conductive vias 809A, 809B being coupled with electrical transmission elements 822A, 822B arranged within dielectric material 824 in the at least one redistribution layer 820. Upper contact pads 826 of the at least one redistribution layer 820 are electrically coupled with lower contact pads 818 of the PIC 810 and with lower contact pads 832 of the IC 830 via bonding bumps 828A, 828B, respectively. In certain embodiments, power and ground signals may be conducted vertically to the IC 830 and the PIC 810 through the central conductive vias 809A and peripheral conductive vias 809B, respectively, and data signals may be communicated laterally through the at least one redistribution layer 820.

In certain embodiments, an electric IC may include one or more through-silicon vias and serve as an interposer between an optical-electrical substrate and a PIC, with optical and electrical coupling between the PIC and the optical-electrical substrate.

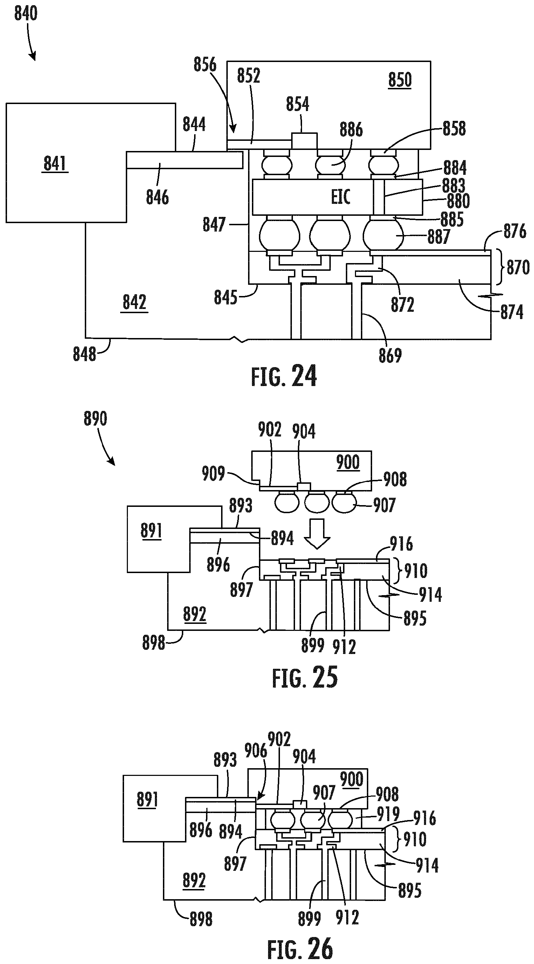

**FIG. 24** is a side cross-sectional view of a portion of an opto-electronic assembly 840 according to one embodiment, including an optical-electrical substrate ("substrate") 842 receiving an optical connector 841 and an IC 880 having at least one through-silicon via 883, with the IC 880 serving as an interposer between the substrate 842 and a PIC 850. The substrate 842 defines an upper surface 844, a lower surface 848, and an intermediate surface 845 that is provided at an elevation between the upper and lower surfaces 844, 848. A first wall (or edge) 847 extends vertically between the upper surface 844 and the intermediate surface 845, and bounds a cavity that contains at least one redistribution layer 870. One or more (typically multiple) glass optical waveguides ("waveguides") 846 are defined in the substrate 842 proximate to the upper surface 844, and serve to provide optical connections between the optical connector 841 (e.g., a multi-fiber connector) and waveguide regions 852 arranged along a lower surface of the PIC 850. The waveguide regions 852 are coupled to the glass optical waveguides 846 at an overlap region 856, and are optically coupled to optical transducers 854 of the PIC 850. The substrate 842 includes multiple electrically conductive vias 869 extending between the intermediate surface 845 and the lower surface 848, with at least some of the electrically conductive vias 869 being coupled with electrical transmission elements 872 arranged within dielectric material 874 in at least one redistribution layer 870 supported by the intermediate surface 845. Upper contact pads 876 of the at least one redistribution layer 870 are electrically coupled with lower contact pads 885 of the IC 880 via bonding bumps 887. Similarly, upper contact pads 884 of the IC 880 are electrically coupled with lower contact pads 858 of the PIC 850 via bonding bumps 886, with the through-silicon via 883 creating an electrically conductive path from the PIC 850 through the IC 880 to the at least one first redistribution layer 870.

Various embodiments described previously herein have relied upon evanescent / adiabatic coupling utilizing an overlap between waveguide regions of a PIC and glass optical waveguides of an optical-electrical substrate. Additional embodiments may utilize edge coupling (also known as end-fire coupling) to provide optical coupling between waveguide regions of a PIC and glass optical waveguides of an optical-electrical substrate.

**FIG. 25** is a partially exploded, side cross-sectional view of a portion of an opto-electronic assembly 890 including an optical-electrical substrate ("substrate") 892 receiving an optical connector 891 and configured to receive a PIC 900 having a passive alignment feature 909 (e.g., a notch) to promote edge coupling between waveguide regions 902 of the PIC 900 and glass optical waveguides ("waveguides") 896 of the substrate 892. **FIG. 26** is a side cross-sectional view of the portion of the opto-electronic assembly 890 of **FIG. 25** following mounting of the PIC 900 to the substrate 892. With reference to **FIGS. 25** and **26****,** the substrate 892 defines an upper surface 894, a lower surface 898, and an intermediate surface 895 that is provided at an elevation between the upper and lower surfaces 894, 898. A first wall (or edge) 897 extends vertically between the upper surface 894 and the intermediate surface 895, and bounds a cavity that contains at least one redistribution layer 910. One or more (typically multiple) waveguides 896 are defined in the substrate 892 proximate to the upper surface 894, and serve to provide optical connections between the optical connector 891 (e.g., a multi-fiber connector) and waveguide regions 902 arranged along a lower surface of the PIC 900, which are coupled to optical transducers 904. A covering element 893 may be arranged in contact with the upper surface 894 and be contacted by the passive alignment feature 909 to promote coplanar arrangement (preferably in combination with abutting contact) between the waveguide regions 902 and the waveguides 896 when the PIC 900 is received by the substrate 892. Physical contact between the passive alignment feature 909 and the covering element 893 may be maintained by bonding bumps 907 that couple lower contact pads 908 of the PIC 900 to upper contact pads 916 of the at least one redistribution layer 910. The substrate 892 includes multiple electrically conductive vias 899 extending between the intermediate surface 895 and the lower surface 898, with at least some of the electrically conductive vias 899 being coupled with electrical transmission elements 912 arranged within dielectric material 914 in the at least one redistribution layer 910. In certain embodiments, power and ground signals may be conducted vertically to the PIC 900 through the vias 899.

In certain embodiments, grating coupling may be used to provide optical coupling between waveguide regions of a PIC and glass optical waveguides of an optical-electrical substrate.

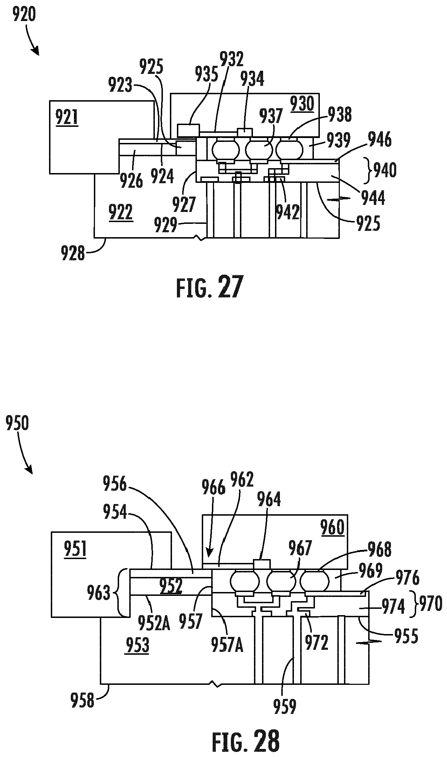

**FIG. 27** is a side cross-sectional view of a portion of an opto-electronic assembly 920 including an optical-electrical substrate ("substrate") 922 receiving an optical connector 921 and a PIC 930, with grating coupling elements 929, 935 arranged between the PIC 930 and glass optical waveguides ("waveguides") 926 of the substrate 922. The substrate 922 defines an upper surface 924, a lower surface 928, and an intermediate surface 925 that is provided at an elevation between the upper and lower surfaces 924, 928. A first wall (or edge) 927 extends vertically between the upper surface 924 and the intermediate surface 925, and bounds a cavity that contains at least one redistribution layer 940. One or more (typically multiple) waveguides 926 are defined in the substrate 922 proximate to the upper surface 924, and serve to provide optical connections between the optical connector 921 (e.g., a multi-fiber connector) and waveguide regions 932 arranged along a lower surface of the PIC 930, which are coupled to optical transducers 934. A covering element 923 may be arranged in contact with the upper surface 924 and be contacted by a portion of the PIC 930 when a grating coupling element 935 of the PIC is proximate to a substrate coupling element 933 of the substrate 922. Examples of suitable coupling elements that may be used include gratings, mirrors, lenses, and/or other optical elements for out-of-plane coupling. In certain embodiments, grating coupling elements 935 and substrate coupling element 923 of the PIC 930 and the substrate 922, respectively, may comprise optics that may be provided by machining, etching, surface deposition, laser processing, or any combination of two or more of the foregoing techniques or other methods known to one skilled in the art. Position of the PIC 930 relative to the substrate 922 may be maintained by bonding bumps 937 (laterally surrounded by an encapsulant material 939) that couple lower contact pads 938 of the PIC 930 to upper contact pads 946 of the at least one redistribution layer 940. The substrate 922 includes multiple electrically conductive vias 929 extending between the intermediate surface 925 and the lower surface 928, with at least some of the electrically conductive vias 929 being coupled with electrical transmission elements 942 arranged within dielectric material 944 in the at least one redistribution layer 940. In certain embodiments, power and ground signals may be conducted vertically to the PIC 930 through the vias 929.

In certain embodiments, an optical-electrical substrate may embody a composite substrate including a glass (or glass-containing) substrate portion defining glass optical waveguides that is mated with (e.g., laminated to) a non-glass (e.g., organic) substrate portion defining conductive vias, and used for mounting one or more optoelectronic devices such as PICs.

**FIG. 28** is a side cross-sectional view of a portion of an opto-electronic assembly 950 including a composite optical-electrical substrate comprising a glass substrate portion 952 defining glass optical waveguides ("waveguides") 956, laminated or otherwise joined (at an interface 952A) over a non-glass substrate portion 953 defining conductive vias 959. The opto-electronic assembly 950 further includes an optical connector 951 and a PIC 960 (e.g., having an integrated electronic IC) received by substrate portions 952, 953. In combination, the glass substrate portion 952 and the non-glass substrate portion 953 include an upper surface 954, a lower surface 958, and an intermediate surface 955 arranged at an elevation between the upper surface 954 and the lower surface 958. The conductive vias 959 extend between the intermediate surface 955 and the lower surface 958 of the non-glass substrate portion 953. As shown, the interface 952A between the glass substrate portion 952 and the non-glass substrate portion 953 is arranged at an elevation between the upper surface 954 and the intermediate surface 955, wherein an elevated portion 963 of the composite substrate includes the entirety of the glass substrate portion 952 and part of the non-glass substrate portion 953. The elevated portion 963 includes wall (or edge) portions 957, 957A that extend between the upper surface 954 and the intermediate surface 955, and that laterally bound at least one redistribution layer 970 supported by the intermediate surface 955. The elevated portion 963 is arranged to contact the PIC 960 to promote optical coupling between the waveguides 956 of the glass substrate portion 952 and waveguide regions 962 of the PIC 960, with each waveguide region 962 being coupled with an optical transducer 964 of the PIC 960. The waveguide regions 962 overlap the waveguides 956 of the glass substrate portion 952 at waveguide overlap regions 966 that promote optical coupling between the waveguide regions 962 and the waveguides 956. Bonding bumps 967 (which are laterally surrounded by encapsulant material 969) are provided between electrical contact pads 968 of the PIC 960 and contact pads 976 of the at least one redistribution layer 970. Presence of the waveguides 956 at a position that is elevated relative to the at least one redistribution layer 970 provides vertical space for the bonding bumps 967 to be arranged between the intermediate surface 955 and the PIC 960. Electrical transmission elements 972 and/or surface traces of the at least one redistribution layer 970, which may be arranged in an dielectric material 974, may be used to adjust a pitch and convey electrical signals between the PIC 960 and electrically conductive vias 959 defined in the non-glass substrate portion 953.

In certain embodiments, an optical-electrical substrate may embody a composite substrate including a glass (or glass-containing) substrate portion defining glass optical waveguides and conductive vias that is mated with (e.g., embedded in) a non-glass (e.g., organic) substrate portion defining conductive vias, and used for mounting one or more optoelectronic devices such as PICs.

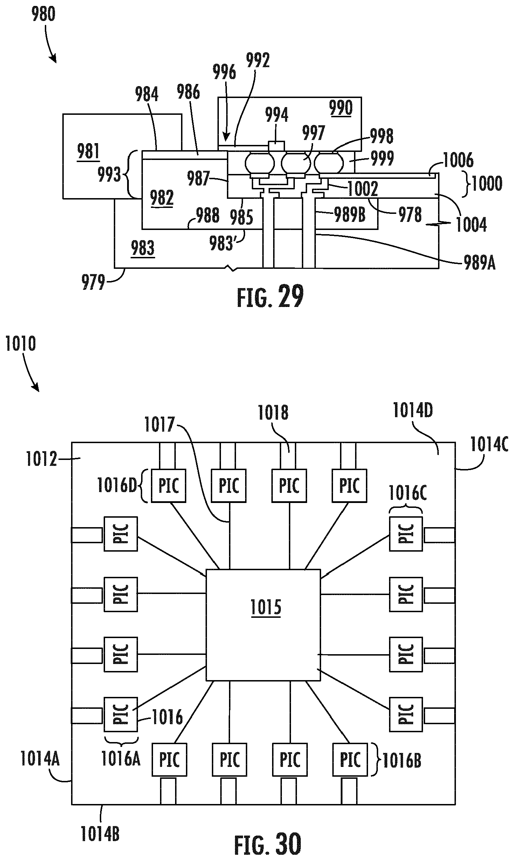

**FIG. 29** is a side cross-sectional view of a portion of an opto-electronic assembly 980 including a composite optical-electrical substrate comprising a glass substrate portion 982 defining glass optical waveguides ("waveguides") 986, partially embedded in a cavity 983' of a non-glass substrate portion 983. The opto-electronic assembly 980 further includes an optical connector 981 and a PIC 990 (e.g., having an integrated electronic IC) received by the glass substrate portion 982. The glass substrate portion 982 includes an upper surface 984, a lower surface 988, and an intermediate surface 985 arranged at an elevation between the upper surface 984 and the lower surface 988. An elevated portion 993 of the glass substrate portion 982 extends upward relative to the intermediate surface 985 and is bounded by a first wall (or edge) 987 extending between the upper surface 984 and the intermediate surface 985. The first wall 987 serves as a lateral boundary for at least one redistribution layer 1000 that includes electrically transmissive elements 1002 and a dielectric material 1004 as well as upper contact pads 1006. One or more glass optical waveguides ("waveguides") 986 are defined in the glass substrate portion 982 proximate to the upper surface 984, and serve to provide optical connections between the optical connector 981 (e.g., a multi-fiber connector) and waveguide regions 992 arranged along a lower surface of the PIC 990, with each waveguide region 992 being coupled with an optical transducer 994 of the PIC 990. The waveguide regions 992 overlap the waveguides 986 of the glass substrate portion 982 at waveguide overlap regions 996 that promote optical coupling between the waveguide regions 992 and the waveguides 986. The glass substrate portion 982 defines conductive vias 989B (extending between the intermediate surface 985 and the lower surface 988) that are registered with conductive vias 989A defined in the non-glass substrate portion 983, with the respective vias 989A, 989B being in conductive electrical communication with electrical transmission elements 1002 and upper contact pads 1006 of the at least one redistribution layer 1000. Bonding bumps 997 are provided between electrical contact pads 998 of the PIC 990 and the upper contact pads 1006 of the at least one redistribution layer 1000. Presence of the waveguides 986 at a position that is elevated relative to the at least one redistribution layer 1000 provides vertical space for the bonding bumps 997 to be arranged between the intermediate surface 985 and the PIC 990 while the PIC 990 is optically coupled with the waveguides 986 of the glass substrate portion 982. The non-glass substrate portion 983 includes a lower surface 979 and an upper surface 978 that contacts the optical connector 981 as well as a portion of the at least one redistribution layer 1000.

Optical-electrical substrates of various shapes may be provided with glass optical waveguides of any suitable number and configuration, together with electrical transmission elements (e.g., traces), for interconnecting optoelectronic components (e.g., optical transceivers, PICs, and electronic ICs such as ASICs) according to any desirable number and layouts. Glass optical waveguides may be used to interconnect optical ports of PICs to edges of a substrate to permit interconnection with optical fibers. The number of PICs and electronic ICs, as well as the size and waveguide geometry, can differ. Glass optical waveguides used to interface with PICs may be provided in various shapes and configurations, such as straight, S-bend, 90 degree arcs, crosses, tapers, mode-converters, fan-out, arrayed waveguide gratings (AWGs), or combinations of the foregoing.

**FIG. 30** is a schematic top plan view of an assembly 1010 including an optical-electrical substrate ("substrate") 1012 supporting a centrally located electronic IC 1015 (e.g., an ASIC) as well as four peripherally located groups 1016A-1016D of PICs 1016 (e.g., transceivers) according to one potential layout including straight glass optical waveguide groups 1018 plus electrical traces 1017 (also referred to as electrical connections 1017). As shown, the substrate 1012 is rectangular in shape with four edges 1014A-1014D, with each group 1016A-1016D of PICs 1016 being arranged parallel to, and proximate to, a different edge 1014A-1014D of the substrate 1012. A total of sixteen PICs 1016 organized into four groups 1016A-1016D are illustrated, but any suitable number of PICs 1016 and groups 1016A-1016D thereof may be provided. Each PIC 1016 has an associated glass optical waveguide group 1018 (i.e., arranged in a straight configuration and extending to an edge 1014A-1014D of the substrate 1012) and electrical connections 1017 to the IC 1015. In certain embodiments, each glass optical waveguide group 1018 may include 8, 16, 32, 64, or more glass optical waveguides defined in the substrate 1012. Although each electrical connection 1017 is illustrated as a single trace or line, it is to be appreciated that each electrical connection 1017 may include numerous connections arranged in parallel.

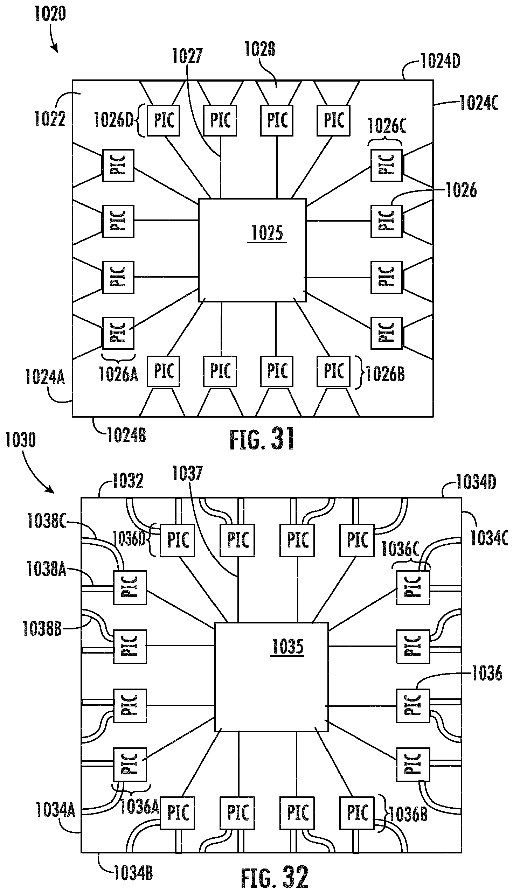

**FIG. 31** is a schematic top plan view of an assembly 1020 including an optical-electrical substrate ("substrate") 1022 supporting a centrally located electronic IC 1025 (e.g., an ASIC) as well as four peripherally located groups 1026A-1026D of PICs 1026 (e.g., transceivers) according to one potential layout including fan-out glass optical waveguide groups 1028 and electrical traces 1027 (also referred to as electrical connections 1027). As shown, the substrate 1022 is rectangular in shape with four edges 1024A-1024D, with each group 1026A-1026D of PICs 1026 being arranged parallel to, and proximate to, a different edge 1024A-1024D of the substrate 1022. A total of sixteen PICs 1026 organized into four groups 1026A-1026D are illustrated. Each PIC 1026 has an associated glass optical waveguide group 1028 (i.e., arranged in a fan-out configuration and extending to an edge 1024A-1024D of the substrate 1022) and electrical connections 1027 to the IC 1025. In certain embodiments, each glass optical waveguide group 1028 may include 8, 16, 32, 64, or more glass optical waveguides defined in the substrate 1022. Although each electrical connection 1027 is illustrated as a single trace or line, it is to be appreciated that each electrical connection 1027 may include numerous connections arranged in parallel.

**FIG. 32** is a schematic top plan view of an assembly 1030 including an optical-electrical substrate ("substrate") 1032 supporting a centrally located electronic IC 1035 (e.g., an ASIC) as well as four peripherally located groups 1036A-1036D of PICs 1036 (e.g., transceivers) according to one potential layout including combinations of straight waveguide groups 1038A, S-shaped waveguide groups 1038B, and ninety-degree arc waveguide groups 1038C (e.g., to form branched and/or fan-out waveguide group configurations), extending from edges 1034A-1034D of the optical-electrical substrate 1032 to the PICs 1036. As shown, the substrate 1032 is rectangular in shape with four edges 1034A-1034D, with each group 1036A-1036D of PICs 1036 being arranged parallel to, and proximate to, a different edge 1034A-1034D of the substrate 1032. Each PIC 1036 has an associated glass optical waveguide group 1038A-1038C extending to an edge 1034A-1034D of the substrate 1032, as well as electrical connections 1037 to the IC 1035. In certain embodiments, each glass optical waveguide group 1038A-1038C may include 8, 16, 32, 64, or more glass optical waveguides defined in the substrate 1032. Although each electrical connection 1037 is illustrated as a single trace or line, it is to be appreciated that each electrical connection 1037 may include numerous connections arranged in parallel.

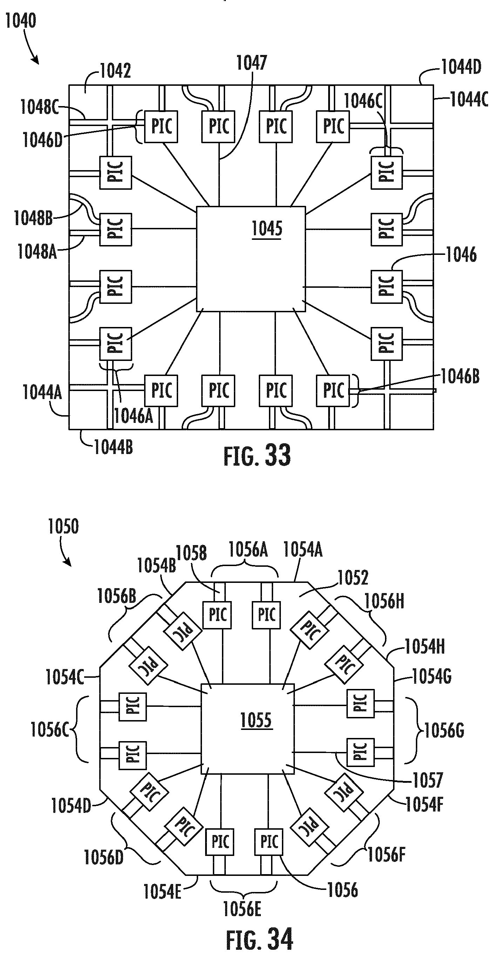

**FIG. 33** is a schematic top plan view of an assembly 1040 including optical-electrical substrate ("substrate") 1042 supporting a centrally located electronic IC 1045 (e.g., an ASIC) as well as four peripherally located groups 1046A-1046D of PICs 1046 (e.g., transceivers) according to one potential layout including combinations of straight waveguide groups 1048A and S-shaped waveguide groups 1048B to form branched and crossing waveguide group 1048 configurations, extending from edges 1044A-1044D of the optical-electrical substrate 1042 to the PICs 1046. As shown, the substrate 1042 is rectangular in shape with four edges 1044A-1044D, with each group 1046A-1046D of PICs 1046 being arranged parallel to, and proximate to, a different edge 1044A-1044D of the substrate 1042. Each PIC 1046 has an associated glass optical waveguide group 1048 extending to an edge 1044A-1044D of the substrate 1042, as well as and electrical connections 1047 to the IC 1045. In certain embodiments, each glass optical waveguide group 1048 may include 8, 16, 32, 64, or more glass optical waveguides defined in the substrate 1042. Although each electrical connection 1047 is illustrated as a single trace or line, it is to be appreciated that each electrical connection 1047 may include numerous connections arranged in parallel.

**FIG. 34** is a schematic top plan view of an assembly 1050 including an optical-electrical substrate ("substrate") 1052 having a non-rectangular (e.g., octagonal) shape supporting a centrally located electronic IC 1055 (e.g., an ASIC) as well as eight peripherally located groups 1056A-1056H of PICs 1056 (e.g., transceivers) according to one potential layout including straight waveguide groups 1058 extending from edges 1054A-1054D of the optical-electrical substrate 1052 to the PICs 1056. As shown, the substrate 1052 is octagonal in shape with eight edges 1054A-1054H, with each group 1056A-1056H of PICs 1056 being arranged parallel to, and proximate to, a different edge 1054A-1054H of the substrate 1052. Each PIC 1056 has an associated glass optical waveguide group 1058 extending to an edge 1054A-1054D of the substrate 1052, as well as and electrical connections 1057 to the IC 1055. In certain embodiments, each glass optical waveguide group 1058 may include 8, 16, 32, 64, or more glass optical waveguides defined in the substrate 1052. Although each electrical connection 1057 is illustrated as a single trace or line, it is to be appreciated that each electrical connection 1057 may include numerous connections arranged in parallel.

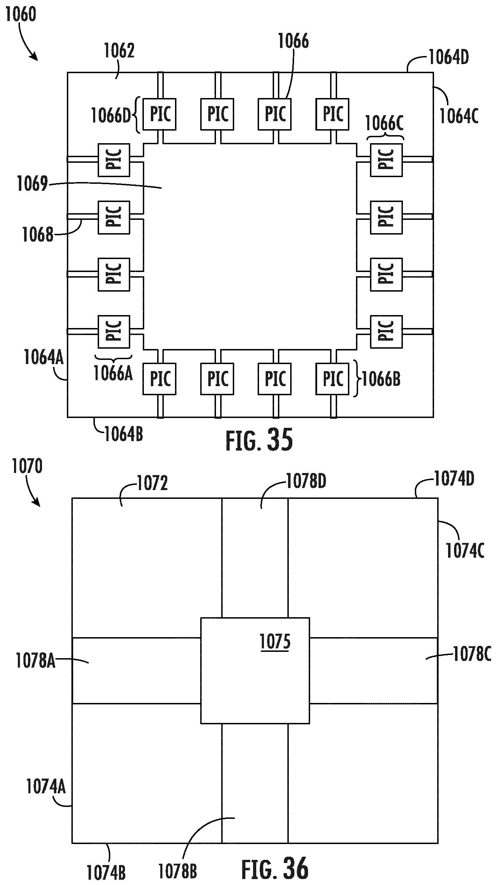

**FIG. 35** is a schematic top plan view of an assembly 1060 including a rectangular optical-electrical substrate ("substrate") 1062 supporting four peripherally located groups 1066A-1066D of PICs 1066, with multiple waveguide groups 1068 connecting the PICs to edges 1064A-1064D of the substrate 1062, and with a waveguide routing area 1069 serving as part of an optical circuit to interconnect the PICs 1066. Optical connectors (not shown) including optical fibers may connect to the waveguide groups 1068 around the edges 1064A-1064D of the substrate 1062.

**FIG. 36** is a schematic top plan view of an assembly 1070 including a rectangular optical-electrical substrate ("substrate") 1072 supporting a high port count PIC 1075, with multiple waveguide groups 1078A-1078D connecting the PIC 1075 and extending from four edges 1074A-1074D of the substrate 1072. In certain embodiments, the waveguide groups 1078A-1078D may embody fan-out groups with a reduced pitch between waveguides proximate to the PIC 1075, and an increased pitch between waveguides proximate to the edge 1074A-1074D. Optical connectors (not shown) including optical fibers may connect to the waveguide groups 1078A-1078D at the edges 1074A-1074D of the substrate 1072.

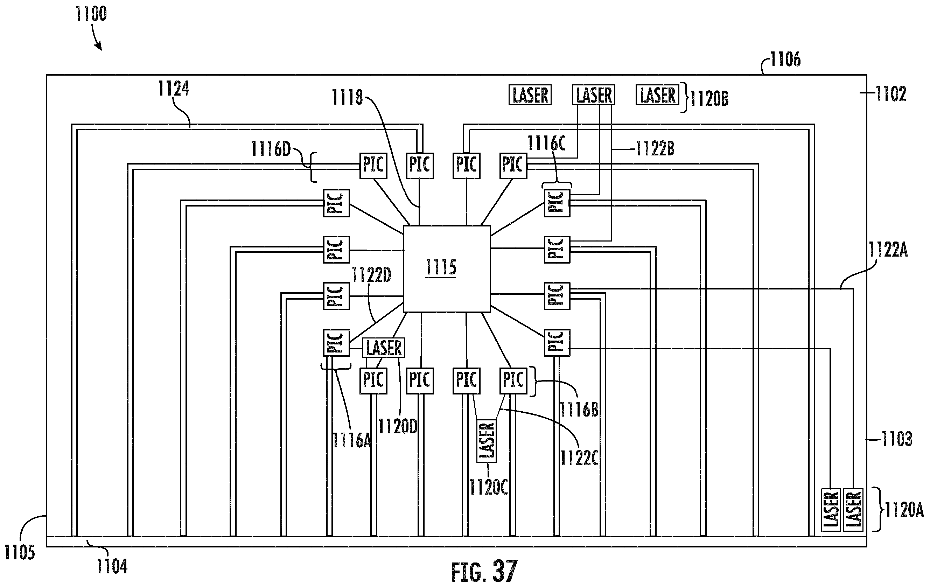

**FIG. 37** is a schematic top plan view of an assembly 1100 including an optical-electrical substrate ("substrate") 1102 serving as a motherboard for connecting to one or more fiber interfaces at a front panel (or backplane) 1104 with PICs 1116A-1116D located mid-board, and can include board-mounted lasers 1120A-1120D. The substrate 1102 includes lateral edges 1103, 1105 and a rear edge 1106. Optical waveguide groups 1118 are coupled between the PICs 1116A-1116D (e.g., transceivers) and the front panel 1104. Certain lasers 1120A may be arranged at the front panel 1104, and/or lasers 1120B may be located proximate to the rear edge, and/or lasers 1120C-1120D may be arranged mid-board. In certain embodiments, waveguides 1122A-1122D may feed one or more PICs 1116A-1116D with continuous wave emissions from the lasers 1120C-1120D. Electrical connections 1124 are further provided between the PICs 1116A-1116D and the IC 1115, wherein it is to be appreciated that each electrical connection 1124 may include numerous connections arranged in parallel, despite being illustrated as a single line.

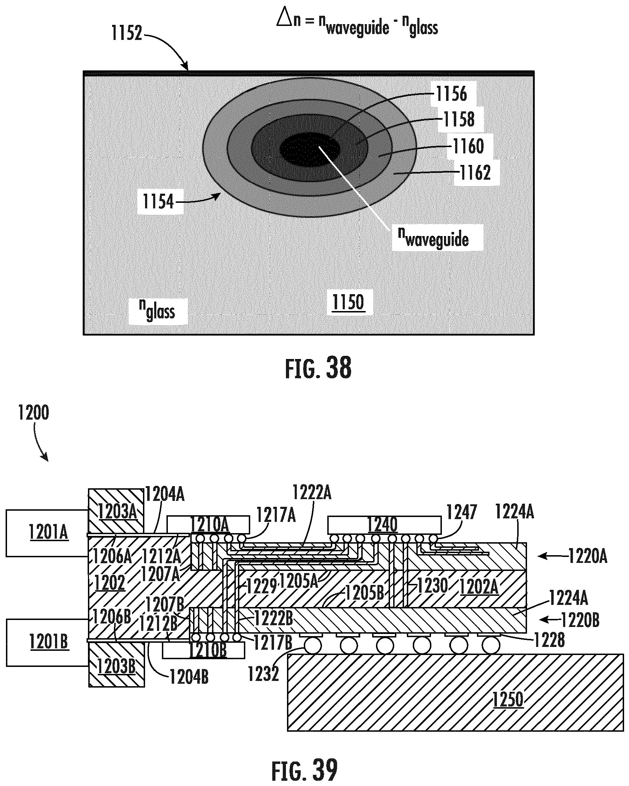

A single-mode ion exchange waveguide realized in a glass substrate was modeled, based on a glass refractive index (n_{glass}) range in a range 1.44 to 1.54 with a waveguide index change (Δn) between 0.002 and 0.06. **FIG. 38** provides a schematic representation of refractive index profile for an ion exchange glass waveguide 1154 arranged within a glass substrate 1150 proximate to an upper surface 1152 of the substrate 1150. As shown, the ion exchange glass waveguide 1154 may include a central region 1156, and multiple (e.g., concentric) surrounding regions 1158, 1160, 1162, wherein refractive index values for the surrounding regions 1158, 1160, 1162 may be characterized by gradation from the central region 1156 to the surrounding glass of the substrate 1150.

In certain embodiments, glass substrates may include glass optical waveguides along multiple (e.g., upper and lower) surfaces thereof, and may be arranged to receive at least one PIC along the upper surface plus at least one PIC along the lower surface.

**FIG. 39** a side cross-sectional view of a portion of an opto-electronic assembly 1200 including an optical-electrical substrate ("substrate") 1202 receiving first and second optical connectors 1201A, 1201B and having glass optical waveguides 1206A, 1206B defined along opposing first and second outer (which may be considered "upper" and "lower" depending on the relative direction) surfaces 1204A, 1204B thereof, with PICs 1210A, 1210B mounted along the first and second outer surfaces 1204A, 1204B. The substrate 1202 additionally defines first and second intermediate surfaces 1205A, 1205B arranged at elevations between the first and second outer surfaces 1204A, 1204B. A first wall (or edge) 1207A extends vertically between the first outer surface 1204A and the first intermediate surface 1205A, and bounds a first cavity that contains at least one first redistribution layer 1220A. Similarly, a second wall (or edge) 1207B (which may be coplanar with the first wall 1207A) extends vertically between the second outer surface 1204B and the second intermediate surface 1215B, and bounds a second cavity that contains at least one second redistribution layer 1220B. Within the at least one first redistribution layer 1220A, electrical transmission elements 1222A arranged within a first dielectric material 1224A are arranged to couple the first PIC 1210A to an electronic IC (e.g., ASIC) 1240 and to electrically conductive vias 1230 extending through a reduced thickness portion 1202A of the substrate 1202. Within the at least one second redistribution layer 1220B, electrical transmission elements 1222B (in the form of vias) arranged within a second dielectric material 1224B are coupled with electrically conductive vias 1229 in the reduced thickness portion 1202A of the substrate 1202 and coupled to electrical transmission elements 1222A of the at least one first redistribution layer 1220A to electrically couple the second PIC 1210B to the electronic IC 1240. Bonding bumps 1217A, 1217B are provided to couple the first and second PICs 1210A, 1210B to the at least one first and second redistribution layers 1220A, 1220B, respectively, while additional bonding bumps 1247 are provided to couple the electronic IC 1240 to the at least one first redistribution layer 1220A. A first receptacle 1203A arranged along the first outer surface 1204A receives the first optical connector 1201A, and a second receptacle 1203B arranged along the second outer surface 1204B receives the first optical connector 1201B. Electrical pads 1228 arranged along the at least one second redistribution layer 1228 are additionally provided, and are coupled with bonding bumps 1232 to promote electrical connection between the substrate 1202 and a secondary (e.g., organic, ceramic, organic-ceramic, glass-organic, or glass) substrate 1250, which may be embodied in a printed circuit board.

In certain embodiments, the mode size of a single mode glass waveguide is comparable to that of the standard single mode fiber (with a mode field diameter of about 10 microns), and therefore is mismatched with the smaller mode of the Si-waveguide in integrated photonic chips. An end-to-end coupling between the glass waveguide and integrated photonics waveguide can be implemented based on an inverted taper spot-size convertor concept. The mode of the glass waveguide may be matched to the expanded mode supported by the tapered tip (∼50-100 nm width) of the convertor. In certain embodiments, the mode transitions adiabatically, with minimal optical power loss, to a smaller mode field of the on-chip integrated photonics waveguide. For a nominal Si strip waveguide thickness of 220 nm and a taper width varying from 60-80 nm to a nominal 450 nm, coupling loss of <1 dB can be achieved over a roughly 200 µm taper length. For a transverse electric (TE) polarization, the wavelength dependence of these couplers shows a 3 dB bandwidth of 200-300 nm and tolerance to misalignment offsets of ∼1 um. Another coupling scheme may be based on evanescent coupling between the modes of glass and PIC waveguides, in which the PIC waveguide is tapered so that its optical mode overlaps with the single mode of the glass waveguide over a certain length, by overlapping evanescent fields of the modes due to proximity of waveguides, and by matching their propagation constants via tapering of a Si waveguide. Simulations performed for a non-linear taper 2.5mm in length indicate a 0.25dB loss with a 1 µm thin index matching adhesive (n=1.47) between the Si and glass waveguides. To overcome the height gaps for flip chip bonding of a Si chip, a precision glass cavity can be etched.

Although various embodiments refer to multi-fiber interface apparatuses as being intended for use with a PIC, embodiments herein may be used with other components, such as vertical cavity surface emitting lasers (VCSELs), photodiodes, integrated silicon photonic components, and the like.

Those skilled in the art will appreciate that other modifications and variations can be made without departing from the spirit or scope of the invention.

Since modifications, combinations, sub-combinations, and variations of the disclosed embodiments incorporating the spirit and substance of the invention may occur to persons skilled in the art, the invention should be construed to include everything within the scope of the appended claims and their equivalents. The claims as set forth below are incorporated into and constitute part of this detailed description.

It will also be apparent to those skilled in the art that unless otherwise expressly stated, it is in no way intended that any method in this disclosure be construed as requiring that its steps be performed in a specific order. Accordingly, where a method claim below does not actually recite an order to be followed by its steps or it is not otherwise specifically stated in the claims or descriptions that the steps are to be limited to a specific order, it is no way intended that any particular order be inferred. Moreover, where a method claim below does not explicitly recite a step mentioned in the description above, it should not be assumed that the step is required by the claim.

## Claims

1. An optical-electrical substrate configured for providing electrical and optical connections to at least one photonic integrated circuit, the optical-electrical substrate comprising:
a glass body comprising an upper surface, an intermediate surface, and a lower surface;
a plurality of glass optical waveguides integrated into the glass body; and
a plurality of electrically conductive vias extending through a portion of the glass body from the intermediate surface to the lower surface;
wherein:
the intermediate surface is arranged at an elevation that is between the upper surface and the lower surface;
at least a portion of the intermediate surface is laterally offset relative to the upper surface; and
each of the upper surface and the intermediate surface opposes the lower surface.

2. The optical-electrical substrate of claim 1, wherein:
the glass body comprises an upper glass body portion, a lower glass body portion, and a bonding surface between the upper glass body portion and the lower glass body portion;
the upper glass body portion defines the upper surface; and
the lower glass body portion defines the intermediate surface and the lower surface.

3. The optical-electrical substrate of claim 1, wherein the glass body comprises a unitary body structure that is devoid of any bonding surface between different portions of the glass body.

4. The optical-electrical substrate of any of claims 1-3, wherein at least some glass optical waveguides of the plurality of glass optical waveguides comprise ion-exchanged glass optical waveguides.

5. The optical-electrical substrate of any of claims 1-4, wherein at least some glass optical waveguides of the plurality of glass optical waveguides comprise laser processed glass optical waveguides.

6. The optical-electrical substrate of any of claims 1-5, wherein at least some glass optical waveguides of the plurality of glass optical waveguides comprise etched or deposited glass optical waveguides.

7. The optical-electrical substrate of any of claims 1-6, further comprising a plurality of electrical contact pads arranged along the lower surface and in conductive electrical communication with the plurality of electrically conductive vias.

8. The optical-electrical substrate of any of claims 1-7, wherein the glass body defines a first wall extending between the upper surface and the intermediate surface, and the first wall laterally bounds at least a portion of a cavity configured to receive an integrated circuit in electrical communication with the at least one photonic integrated circuit.

9. The optical-electrical substrate of any of claims 1-8, wherein the glass body defines one or more edges or surfaces providing passive alignment features for registering the at least one photonic integrated circuit with the glass body.

10. The optical-electrical substrate of any of claims 1-9, mounted to a secondary substrate, with the plurality of electrically conductive vias of the optical-electrical substrate being in conductive electrical communication with a plurality of electrically conductive features of the secondary substrate.

11. The optical-electrical substrate of any of claims 1-10, further comprising at least one first redistribution layer arranged on the intermediate surface.

12. The optical-electrical substrate of claim 11, wherein the at least one first redistribution layer comprises a plurality of first redistribution layers, with the plurality of first redistribution layers comprising multiple layers of dielectric polymer having electrical transmission elements arranged therein.

13. The optical-electrical substrate of either claim 11 or 12, further comprising at least one second redistribution layer arranged on the lower surface.

14. A method for providing electrical and optical connections to at least one photonic integrated circuit, the method comprising:
registering a photonic integrated circuit with the optical-electrical substrate of any of claims 1-13;
heating a plurality of bonding bumps arranged between the photonic integrated circuit and the intermediate surface of the glass body of the optical-electrical substrate sufficiently to make a plurality of conductive electrical connections between electrical contacts of the photonic integrated circuit and at least some electrically conductive vias of the plurality of electrically conductive vias of the optical-electrical substrate; and
providing optically transmissive paths between optical coupling areas of the photonic integrated circuit and at least some glass optical waveguides of the plurality of glass optical waveguides of the optical-electrical substrate.

15. The method of claim 14, wherein the heating of the plurality of bonding bumps comprises use of a solder reflow technique or a thermo-compression technique.
